(19) Europäisches Patentamt
European Patent Office
Office européen des brevets

(11) **EP 1 580 597 A2**

(12) **EUROPEAN PATENT APPLICATION**


(43) Date of publication:
**28.09.2005 Bulletin 2005/39**

(51) Int Cl.[7]: **G03F 7/00**

(21) Application number: **05251868.5**

(22) Date of filing: **24.03.2005**

(84) Designated Contracting States:
**AT BE BG CH CY CZ DE DK EE ES FI FR GB GR HU IE IS IT LI LT LU MC NL PL PT RO SE SI SK TR**
Designated Extension States:
**AL BA HR LV MK YU**

(30) Priority: **26.03.2004 JP 2004091983**



(71) Applicant: **FUJI PHOTO FILM CO., LTD.**
**Kanagawa (JP)**

(72) Inventors:
- **Takizawa, Hiroo c/o Fuji Photo Film Co., Ltd.**
**Minami-Ashigara-shi Kanagawa (JP)**
- **Inoue, Noriko c/o Fuji Photo Film Co., Ltd.**
**Odawara-shi Kanagawa (JP)**

(74) Representative: **Matthews, Derek Peter**
**Frank B. Dehn & Co.,**
**179 Queen Victoria Street**
**London EC4V 4EL (GB)**


(54) **Hologram recording material, hologram recording method and optical recording medium**


(57) A hologram recording material comprising at least one metal complex dye as a sensitizing dye.


*FIG. 1*

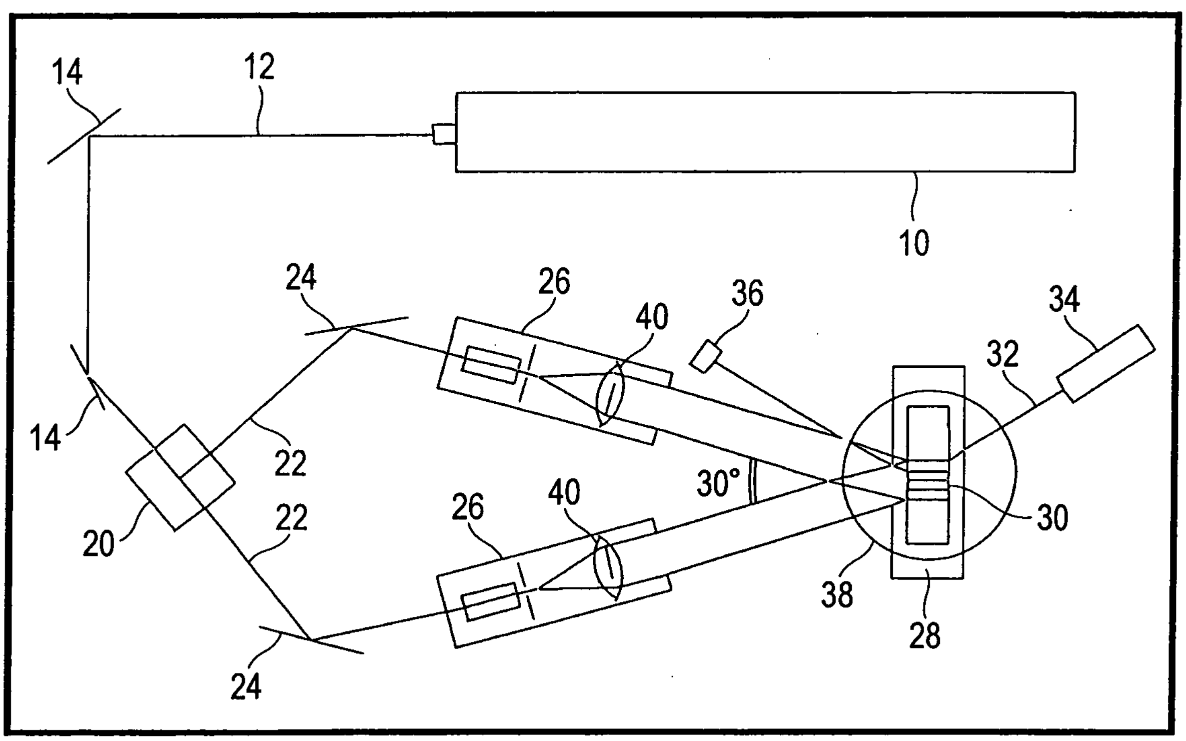





Printed by Jouve, 75001 PARIS (FR)

## Description

## Background of the Invention

### 1. Field of the Invention

The present invention relates to a hologram recording material and hologram recording method which can be applied to high density optical recording medium, three-dimensional display, holographic optical element, etc.

### 2. Description of the Related Art

The general principle of preparation of hologram is described in some literatures and technical books, e.g., Junpei Tsujiuchi, "Holographic Display", Sangyo Tosho, Chapter 2. In accordance with these literatures and technical books, a recording object is irradiated with one of two fluxes of coherent laser beams and a photosensitive hologram recording material is disposed in a position such that all the light beams reflected by the recording object can be received. Besides the light beam reflected by the recording object, the other coherent light beam is incident on the hologram recording material without hitting the object. The light beam reflected by the object is called object light. The light beam with which the recording material is directly irradiated is called reference light. The band of interference of reference light with object light is then recorded as image data. Subsequently, when the hologram recording material thus processed is irradiated with the same light beam (reproducing light beam) as the reference light, the hologram performs diffraction in such a manner that the wave front of the first reflected light which has reached the recording material from the object during recording is reproduced. As a result, substantially the same object image as the real image of the object can be three-dimensionally observed.
The hologram formed by allowing reference light beam and object light beam to be incident on the hologram recording material in the same direction is called transmission hologram. The interference band is formed in the direction perpendicular or substantially perpendicular to the surface of the recording material at an interval of from about 1,000 to 3,000 lines per mm.
On the other hand, the hologram formed by allowing reference light beam and object light beam to be incident on the hologram recording material in opposite directions is normally called reflection hologram. The interference band is formed in the direction parallel to or substantially parallel to the surface of the recording material at an interval of from about 3,000 to 7,000 lines per mm.
The transmission hologram can be prepared by any known method as disclosed in JP-A-6-43634. The reflection hologram can be prepared by any known method as disclosed in JP-A-2-3082, JP-A-3-50588, etc.
On the other hand, the hologram having a sufficiently thick layer relative to the interval of interference band (normally five times the interval of interference band or about 1 μm or more) is called volume hologram.
On the contrary, the hologram having a layer thickness which is five times or less the interval of interference band or about 1 μm or less is called plane or surface hologram.
Further, the hologram involving the absorption by dye or silver causing the recording of an interference band is called amplified hologram. The hologram involving recording by surface relief or refractive index modulation is called phase hologram. The amplified hologram is subject to drastic drop of light diffraction efficiency or reflectance due to absorption of light and thus is disadvantageous in percent utilization of light. In general, the phase hologram is preferably used.
In accordance with the volume phase type hologram, many interference bands having different refractive indexes are formed in the hologram recording material without by making optical absorption, making it possible to modulate the phase of light without absorbing light.
In particular, the reflection volume phase type hologram is also called Lipman type hologram. In accordance with the reflection volume phase type hologram, wavelength-selective reflection involving Bragg diffraction allows the formation of full-color image, reproduction of white color and enhancement of resolution at a high diffraction efficiency, making it possible to provide a high resolution full-color three-dimensional display.
In recent years, hologram has been put into practical use in the art of holographic optical element (HOE) such as headup display (HUD) to be mounted on automobile, pickup lens for optical disc, head mount display, color filter for liquid crystal and reflection type liquid crystal reflector by making the use of its wavelength-selective reflectivity.
Studies have been made also on the practical use or application of hologram to lens, diffraction grating, interference filter, connector for optical fiber, light polarizer for facsimile, window glass for building, etc.
In the recent tend for highly informative society, networks such as internet and highvision TV have bee rapidly spread. Further, with the operation of HDTV (high definition television) close at hand, there has been a growing demand for high density recording medium for simply recording image data having a capacity of 100 GB or more at reduced cost also in consumers' use.

In the trend for enhancement of computer capacity, an ultrahigh density recording medium capable of recording data having a capacity of about 1 TB or more at a high rate and reduced cost has been desired also in business uses such as computer backup and broadcast backup.

Under these circumstances, replaceable and random-accessible small-sized inexpensive optical recording media have been noted more than ever relative to magnetic tapes, which are not random-accessible, and hard discs, which are not replaceable and are subject to failure. Speaking from the standpoint of physical principle, however, existing two-dimensional optical recording media such as DVD-R allow recording of 25 GB data at greatest per one side even if the wavelength of the recording light beam is reduced. Thus, these two-dimensional recording media cannot be expected to have a recording capacity great enough to meet the future demand.

Then, three-dimensional optical recording media which perform recording in the thickness direction have been recently noted as ultimate ultrahigh density recording media. Effective methods for this system include method involving the use of two-photon absorbing material and method involving the use of holography (interference). Therefore, volume phase type hologram recording materials have recently been suddenly noted as three-dimensional optical recording media (holographic memory).

In operation, the holographic memory comprising a volume phase type hologram recording material records many two-dimensional digital data (called signal light) using a spatial light modulation element (SLM) such as DMD and LCD instead of object light reflected by the three-dimensional object. Since the recording involves multiplexed recording such as angle-multiplexed recording, phase-multiplexed recording, wavelength- multiplexed recording and shift-multiplexed recording, a capacity as high as up to 1 TB can be attained. Further, reading is normally accomplished by the use of CCD, CMOS or the like. These elements allow parallel writing/reading, making it possible to raise the transfer rate up to 1 Gbps.

However, the hologram recording materials to be used in holographic memory have severer requirements than for the three-dimensional display and HOE as follows.

(1) To have a high sensitivity.
(2) To have a high resolution.
(3) To have a high hologram diffraction efficiency.
(4) To use a fast dry processing during recording.
(5) To allow multiplexed recording (broad dynamic range).
(6) To have a small shrinkage after recording.
(7) To have good hologram storage properties.

In particular, the requirements (1) (To have a high sensitivity), (3) (To have a high hologram diffraction efficiency), (4) (To use a fast dry processing during recording), (6) (To have a small shrinkage after recording) and (7) (To have good hologram storage properties) are chemically opposing properties. It is very difficult to meet these requirements at the same time.

Examples of known volume phase type hologram recording materials include write-once-read-many type hologram recording materials such as gelatin bichromate process hologram recording material, bleached silver halide process hologram recording material and photopolymer process hologram recording material and rewritable type hologram recording materials such as photorefractive process hologram recording material and photochromic polymer process hologram recording material.

However, none of these known volume phase type hologram recording materials cannot meet all these requirements particularly when used as high sensitivity optical recording medium. Thus, these known volume phase type hologram recording materials leave something to be desired.

In some detail, the gelatin bichromate process hologram recording material is advantageous in that it has a high diffraction efficiency and a low noise but is disadvantageous in that it has extremely poor storage properties, requires wet processing and exhibits a low sensitivity. Thus, the gelatin bichromate process hologram recording material is not suitable for holographic memory.

The bleached silver halide process hologram recording material is advantageous in that it has a high sensitivity but is disadvantageous in that it requires wet processing and troublesome bleaching process, causes great scattering and has a poor light-resistance. Thus, the bleached silver halide process hologram recording material, too, is not suitable for holographic memory.

The photorefractive hologram recording material is advantageous in that it is rewritable but is disadvantageous in that it requires the application of a high electric field during recording and has poor record storage properties.

The photochromic polymer process hologram recording material such as azobenzene polymer process hologram recording material is advantageous in that it is rewritable but is disadvantageous in that it has an extremely low sensitivity and poor record storage properties. For example, WO9744365A1 proposes a rewritable hologram recording material utilizing the refractive anisotropy and orientation control of azobenzene polymer (photochromic polymer). However, this type of a rewritable hologram recording material is disadvantageous in that since the quantum yield of isomerization of azobenzene is low and this process involves orientation change, the sensitivity is extremely low. This type of a rewritable hologram recording material is also disadvantageous in that it has poor record storage properties, which are contrary to rewritability. Thus, this type of a rewritable hologram recording material cannot be put into practical use.

Under these circumstances, the dry-processed photopolymer process hologram recording material disclosed in the above cited JP-A-6-43634, JP-A-2-3082 and JP-A-3-50588 has the following arrangement. In other words, the dry-processed photopolymer process hologram recording material is essentially composed of a binder, a radical-polymerizable monomer and a photopolymerization initiator. In order to enhance refractive index modulation, one of the binder and the radical-polymerizable monomer comprises a compound having an aromatic ring, chlorine or bromine incorporated therein to make a difference in refractive index therebetween. In this arrangement, the hologram exposure causes the progress of polymerization with the monomer and the binder gathering at the bright area and the dark area of the interference band thus formed, making it possible to form a refractive index difference. Thus, it can be said that the dry-processed photopolymer process hologram recording material is a relatively practical hologram recording material which can attain a high diffraction efficiency and dry processing properties at the same time.

However, the dry-processed photopolymer process hologram recording material is disadvantageous in that it has a sensitivity of about one thousandth of that of the bleached silver halide process hologram recording material, requires a heat-fixing step for about 2 hours to enhance diffraction efficiency, requires radical polymerization causing the effect of polymerization inhibition by oxygen and is subject to shrinkage after exposure and fixing and hence change of diffraction wavelength and angle during reproduction. Further, the dry-processed photopolymer process hologram recording material is in the form of soft membrane and lacks storage properties. Accordingly, the dry-processed photopolymer process hologram recording material can be by no means used for holographic memory.

In general, as opposed to radical polymerization, cationic polymerization, particularly cationic polymerization involving the ring opening of an epoxy compound, etc., causes little shrinkage after polymerization and no polymerization inhibition by oxygen. As a result, a rigid membrane can be given. It is also pointed out that cationic polymerization is more suitable for holographic memory than radical polymerization.

For example, JP-A-5-107999 and JP-A-8-16078 disclose a hologram recording material comprising in combination a cationically-polymerizable compound (monomer or oligomer) instead of binder and a sensitizing dye, a radical polymerization initiator, a cationic polymerization initiator and a radical-polymerizable compound.

Further, JP-T-2001-523842 and JP-T-11-512847 disclose a hologram recording material comprising only a sensitizing dye, a cationic polymerization initiator, a cationically- polymerizable compound and a binder but free from radical polymerization.

The aforementioned cationic polymerization process hologram recording material shows some improvement in shrinkage resistance as compared with the radical polymerization process hologram recording material but has a lowered sensitivity as opposed to the improvement. It is thought that this disadvantage gives a great problem in transfer rate during practical use. Further, the cationic polymerization process hologram recording material exhibits a reduced diffraction efficiency that probably gives a great problem in S/N ratio and multiplexed recording properties.

As previously mentioned, the photopolymer process hologram recording method involves the movement of materials. This causes a dilemma. In some detail, when the hologram recording material to be applied to holographic memory is arranged to have better storage properties and shrinkage resistance, the resulting sensitivity is lowered (cationic polymerization process hologram recording material). On the contrary, when the hologram recording material is arranged to have an enhanced sensitivity, the resulting storage properties and shrinkage resistance are deteriorated (radical polymerization process hologram recording material). In order to enhance the recording density of holographic memory, it is essential that multiplexed recording involving more than 50 times, preferably 100 times or more recording jobs be effected. However, since the photopolymer process hologram recording material employs polymerization process involving the movement of materials to perform recording, the recording speed in the latter half of multiplexed recording process, in which most of the compound has been polymerized, is reduced as compared with that in the initial stage of multiplexed recording process. Accordingly, exposure must be adjusted and a broad dynamic range must be used to control the recording speed. This gives a practically great problem.

Further, in order to perform multiplexed recording comprising 100 or more recording jobs, it is normally necessary that the thickness of the hologram recording material be at least 100 μm, preferably 500 μm or more to attain close angle dependence under severe Bragg conditions. In order to record an interference band on the entire surface of the hologram recording material, it is necessary that the hologram recording light be transmitted by the hologram recording material by 10% or more. Accordingly, in the case where an ordinary organic sensitizing dye having a high molar absorptivity is used, it is necessary that the amount of the sensitizing dye be drastically reduced to allow the recording light to be transmitted by such a thick hologram recording material. As a result, the recording sensitivity is drastically lowered to disadvantage.

The dilemma caused by the requirements for higher sensitivity, better storage properties and dry processing properties and the problem of multiplexed recording properties cannot be avoided from the physical standpoint of view

so far as the related art photopolymer process hologram recording material is used. It is also difficult for the silver halide process recording material in principle from the standpoint of dry processing properties to meet the requirements for holographic memory.

In order to apply a hologram recording material to holographic memory, it has been keenly desired to develop quite a new recording system which can give essential solution to these problems, particularly one which can attain higher sensitivity, lower shrinkage, better storage properties, dry processing properties and multiplexed recording properties at the same time.

It has also been keenly desired to develop a sensitizing dye which can be used at a high sensitivity in a hologram recording material having a thickness as high as 100 μm or more to perform multiplexed recording comprising many recording jobs and obtain a high recording density.

**Summary of the Invention**

It is thus an aim of the invention to provide a hologram recording material and hologram recording method which can be applied to high density optical recording medium, three-dimensional display, holographic optical element, etc. and can attain a high sensitivity, high diffraction efficiency, good storage properties, low shrinkage factor, dry processing properties and multiplexed recording properties at the same time. It is another aim of the invention to develop a sensitizing dye which can be used with a high sensitivity even in a hologram recording material having a thickness as great as 100 μm or more, particularly in a high density optical recording medium, to perform multiplexed recording comprising many recording jobs and obtain a high recording density.

As a result of the inventors' extensive studies, the aforementioned aims of the invention were accomplished by the following means.

(1) A hologram recording material comprising at least one metal complex dye as a sensitizing dye.
(2) The hologram recording material as defined in Clause (1), wherein the metal complex dye is a metalocene dye.
(3) The hologram recording material as defined in Clause (1) or (2), wherein the metal complex dye is a metalocene dye represented by general formula (I):

(I)

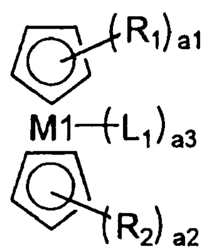

wherein $M_1$ represents a metal atom; $R_1$ and $R_2$ each independently represents a substituent; $L_1$ represents a ligand which can be bonded to $M_1$; a1 and a2 each independently represents an integer of from 0 to 5, and when a1 and a2 each is 2 or more, each of a plurality of $R_1$'s and $R_2$'s may be the same or different and may be connected to each other to form a ring; and a3 represents an integer of from 0 to 6.
(4) The hologram recording material as defined in Clause (3), wherein $M_1$ is any one of Fe, Ru and Ti.
(5) The hologram recording material as defined in any one of Clauses (2) to (4), wherein the metalocene dye is a ferrocene derivative.
(6) The hologram recording material as defined in Clause (5), wherein the metal complex dye is ferrocene.
(7) The hologram recording material as defined in Clause (1), wherein the metal complex dye is a metal complex dye represented by any of general formulae (II-1) to (II-3):

(II-1)

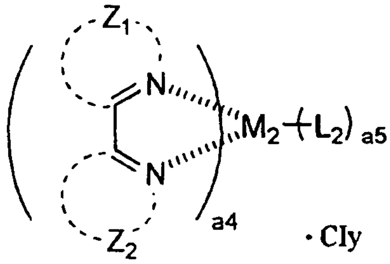

(II-2)

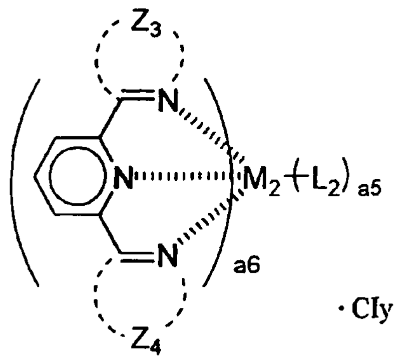

(II-3)

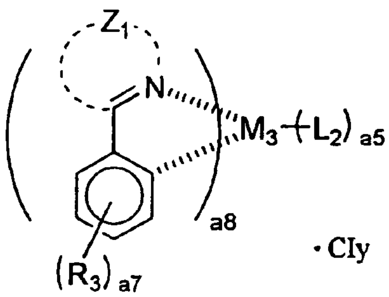

in the formula (II-1), $M_2$ represents a metal atom; $Z_1$ and $Z_2$ each independently represents a non-metal atom group which can form a 5- or 6-membered heterocyclic group; $L_2$ represents a ligand; a4 represents an integer of from 1 to 3; a5 represents an integer of from 0 to 4; CI represents an ion required to neutralize charge; and y represents an integer;

in the formula (II-2), $M_2$, $L_2$, a5, CI and y are as defined above; $Z_3$ and $Z_4$ each independently represents a non-metal atom group which can form a 5- or 6-membered heterocyclic group; a6 represents an integer of 1 or 2;

in the formula (II-3), $Z_1$, $L_2$, a5, CI and y are as defined above; $M_3$ represents a metal atom; $R_3$ represents a substituent; a7 represents an integer of from 0 to 4, and when a7 is 2 or more, the plurality of $R_3$'s may be the same or different and may be connected to each other to form a ring; a8 represents an integer of from 1 to 3.

(8) The hologram recording material as defined in Clause (7), wherein $M_2$ and $M_3$ each independently are any one of Cr, Mn, Fe, Co, Ni, Cu, Zn, Mo, Ru, Rh, Pd, Ag, W, Re, Os, Ir, Pt and Au.

(9) The hologram recording material as defined in Clause (7) or (8), wherein $M_2$ and $M_3$ each independently are any one of Fe, Co, Ni, Cu, Mo, Ru, Rh, W, Re, Os, Ir and Pt.

(10) The hologram recording material as defined in Clause (7), (8) or (9), wherein $M_2$ is any one of Fe, Cu, Ru and Pt.

(11) The hologram recording material as defined in Clause (7), (8) or (9), wherein $M_3$ is any one of Ir and Pt.

(12) The hologram recording material as defined in any one of Clauses (1) and (7) to (11), wherein the metal complex dye is an MLCT type metal complex dye.

(13) The hologram recording material as defined in any one of Clauses (1) and (7) to (12), wherein the metal complex dye is a Ru complex dye.

(14) The hologram recording material as defined in any one of Clauses (1) to (13), wherein the metal complex dye exhibits a molar absorptivity of from 1 to 2,000 at hologram recording wavelength.

(15) The hologram recording material as defined in Clause (14), wherein the metal complex dye which is a sensitizing dye exhibits a molar absorptivity of from not smaller than 5 to not greater than 1,000 at hologram recording wavelength.

(16) The hologram recording material as defined in any one of Clauses (1) to (15), wherein the metal complex dye has a molar absorptivity at hologram recording wavelength not greater than one fifth of that at λmax.

(17) The hologram recording material as defined in Clause (16), wherein the molar absorptivity of the metal complex dye which is a sensitizing dye at hologram recording wavelength is not greater than one tenth of that at λmax.

(18) The hologram recording material as defined in any one of Clauses (1) to (17), which has a thickness of not smaller than 100 μm and comprises a sensitizing dye incorporated therein such that it exhibits a light transmittance of from not smaller than 10% to not greater than 99% at hologram recording wavelength.

(19) The hologram recording material as defined in Clause (18), which has a thickness of not smaller than 500 μm and comprises a sensitizing dye incorporated therein such that it exhibits a light transmittance of from not smaller than 10% to not greater than 99% at hologram recording wavelength.

(20) The hologram recording material as defined in Clause (18) or (19), which has a thickness of not smaller than 100 μm and comprises a sensitizing dye incorporated therein such that it exhibits a light transmittance of from not smaller than 20% to not greater than 90% at hologram recording wavelength.

(21) A hologram recording method using a hologram recording material as defined in any one of Clauses (1) to (20) to record an interference band as refractive index modulation, the method comprising performing any of 1) polymerization reaction, 2) color development reaction, 3) latent image color development- coloring material self-sensitized amplification color development reaction, 4) latent image color development- coloring material sensitized polymerization reaction, 5) change of orientation of a compound having an intrinsic birefringence, 6) dye discoloration reaction and 7) remaining discolorable dye latent image-latent image polymerization reaction.

(22) The hologram recording method as defined in Clause (21), wherein hologram recording involving 3) latent image color development-coloring material self-sensitized amplification color development reaction comprises: a first step of forming a coloring material having no absorption at hologram reproducing light wavelength as a latent image by hologram exposure and; a second step of irradiating the coloring material latent image with light having a wavelength different from hologram exposure wavelength at which the sensitizing dye exhibits a molar absorptivity of 5,000 or less, to cause the self-sensitized amplification of the coloring material and record the interference band as the refractive index modulation, wherein the first and second steps are effected in a dry process.

(23) A hologram recording material for use in a hologram recording method as defined in Clause (21) involving 2) color development reaction or 3) latent image color development- coloring material self-sensitized amplification color development reaction, the hologram recording material comprising:

1) a sensitizing dye comprising a metal complex dye which absorbs light upon hologram exposure to generate excited state; and
2) a dye precursor which can form a coloring material having an absorption at longer wavelength than that of the dye precursor and no absorption at hologram reproducing light wavelength, wherein the interference band-recording component can undergo electron movement or energy movement from the excited state of the sensitizing dye or an excited state of the coloring material, to cause color development leading to the refractive index modulation by which the interference band is recorded.

(24) The hologram recording method as defined in Clause (21), wherein hologram recording involving 4) latent image color development-coloring material sensitized polymerization reaction comprises: a first step of forming a coloring material having no absorption at hologram reproducing light wavelength as a latent image by hologram exposure, and a second step of irradiating the latent image with light having a wavelength different from hologram exposure wavelength to cause polymerization and record the interference band as the refractive index modulation, wherein the first and second steps are effected in a dry process.

(25) A hologram recording material for use in a hologram recording method defined in Clause (24), the hologram recording material comprising:

1) a sensitizing dye comprising a metal complex dye which absorbs light upon hologram exposure to generate an excited state at the first step;
2) an interference band-recording component containing a dye precursor which can form a coloring material having (i) an absorption at longer wavelength than that of the dye precursor, (ii) an absorption at which wavelength the sensitizing dye exhibits a molar absorptivity of 5,000 or less and (iii) no absorption at hologram reproducing light wavelength when electron or energy moves from the excited state of the sensitizing dye at the first step or from an excited state of the coloring material at the second step;
3) a polymerization initiator which can initiate a polymerization of a polymerizable compound when electron or energy moves from the excited state of the sensitizing dye at the first step or from the excited state of the coloring material at the second step;
4) the polymerizable compound; and
5) a binder.

(26) The hologram recording method as defined in Clause (21), wherein hologram recording involving 6) dye discoloration reaction uses a discoloring agent precursor and a discoloring agent, in which, when subjected to hologram exposure, the sensitizing dye or a discolorable dye generates excited state in which it then undergoes energy movement or electron movement with the discoloring agent precursor to cause the discoloring agent precursor to generate a discoloring agent that discolors the discolorable dye, causing the refractive index modulation by which the interference band is formed; and wherein the discoloring agent precursor is any of radical generator, acid generator, base generator, nucleophilic agent generator, electrophilic agent generator and triplet oxygen.
(27) The hologram recording method as defined in Clause (21) or (26), wherein hologram recording involving 7) remaining discolorable dye latent image-latent image polymerization reaction comprises: a first step at which the sensitizing dye having an absorption at hologram exposure wavelength absorbs light during hologram exposure to generate excited state in which it undergoes energy movement or electron movement with a discoloring agent precursor to cause the discoloring agent precursor to generate a discoloring agent that discolors a discolorable dye, so as to form a discolorable dye left undiscolored forms as a latent image; and a second step at which the latent image of the discolorable dye left undiscolored is irradiated with light having a wavelength different from that used for hologram exposure, to activate a polymerization initiator to cause polymerization by which the interference band is recorded as the refractive index modulation.
(28) A hologram recording material for use in the hologram recording method defined in Clause (26) or (27), comprising at least:

1) a sensitizing dye comprising a metal complex dye that absorbs light upon hologram exposure to generate the excited state at the first step;
2) a discolorable dye having a molar absorptivity of 1,000 or less capable of undergoing discoloration due to one of (i) direct electron movement or energy movement to the discolorable dye from the excited state of the sensitizing dye at the first step and (ii) electron movement or energy movement to the discoloring agent precursor from the excited state of the sensitizing dye at the first step;
3) a discoloring agent precursor that can undergo the electron movement or the energy movement from the excited state of the sensitizing dye to generate a discoloring agent at the first step;
4) a polymerization initiator which can undergo the electron movement or the energy movement from an excited state of the discolorable dye left undiscolored to initiate the polymerization of a polymerizable compound at the second step, wherein the polymerization initiator can act as the discoloring agent precursor 3);
5) the polymerizable compound; and
6) a binder.

(29) The hologram recording material as defined in any one of Clauses (1) to (20), (23), (25) and (28), wherein a hologram recording is effected in a non-rewritable process.
(30) A hologram recording method using a hologram recording material defined in any one of Clauses (1) to (20), (23), (25), (28) and (29), the method comprising multiplexed recording comprising 10 or more recording jobs.
(31) A hologram recording method using a hologram recording material defined in any one of Clauses (1) to (20), (23), (25) and (28) to (30), the method comprising multiplexed recording comprising 50 or more recording jobs.
(32) The hologram recording material as defined in Clauses (1) to (20), (23), (25) and (28) to (31), which is provided with a light filter capable of cutting part of wavelength range of ultraviolet ray, visible light and infrared ray other than recording light and reproduced light on the surface or back surface or on the both surfaces thereof.
(33) An optical recording medium comprising a hologram recording material defined in any one of Clauses (1) to (20), (23), (25) and (28) to (32).
(34) An optical recording medium comprising a hologram recording material as defined in any one of Clauses (1) to (20), (23), (25) and (28) to (33), wherein the optical recording medium is stored in a light-screening cartridge during storage.
(35) A three-dimensional display hologram comprising a hologram recording material as defined in any one of Clauses (1) to (20), (23), (25) and (28) to (32).
(36) A holographic optical element comprising a hologram recording material as defined in any one of Clauses (1) to (20), (23), (25) and (28) to (32).

## Brief Description of the Drawings

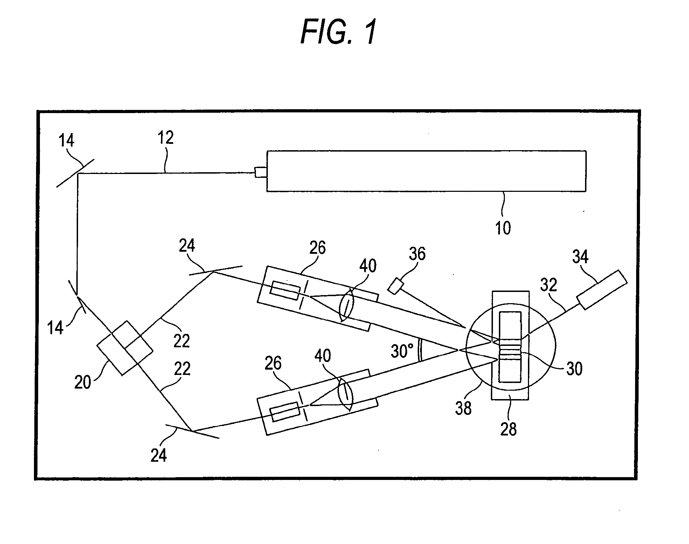

Fig. 1 is a schematic diagram illustrating a two-flux optical system for hologram exposure.

## Detailed Description of the Invention

The hologram recording method and hologram recording material of the invention will be further described hereinafter.

The hologram recording method of the invention preferably comprises performing any of 1) polymerization reaction, 2) color development reaction, 3) latent image color development-coloring material self-sensitized amplification color development reaction, 4) latent image color development-coloring material sensitized polymerization reaction, 5) change of orientation of a compound having an intrinsic birefringence, 6) dye discoloration reaction and 7) remaining discolorable dye latent image-latent image polymerization reaction, more preferably any of 2) color development reaction, 3) latent image color development-coloring material self-sensitized amplification color development reaction, 4) latent image color development-coloring material sensitized polymerization reaction, 6) dye discoloration reaction and 7) remaining discolorable dye latent image-latent image polymerization reaction, even more preferably any of 2) color development reaction, 4) latent image color development-coloring material sensitized polymerization reaction, 6) dye discoloration reaction and 7) remaining discolorable dye latent image-latent image polymerization reaction, to record an interference band as refractive index modulation.

It is preferred that the hologram recording material of the invention be not subjected to wet process.

The hologram recording material of the invention is preferably a recording material adapted to perform volume phase type hologram recording. The term "volume phase type hologram recording" as used herein is meant to indicate recording of many interference bands comprising from 1,000 to 100,000 lines per mm in the thickness direction as refractive index modulation in parallel or substantially parallel to the surface of the recording material (reflection type) or perpendicular or substantially perpendicular to the surface of the recording material as previously mentioned.

The light beam to be used in the hologram recording method of the invention is preferably any of ultraviolet ray, visible light and infrared ray having a wavelength of from 200 to 2,000 nm, more preferably ultraviolet ray or visible light having a wavelength of from 300 to 700 nm, even more preferably visible light having a wavelength of from 400 to 700 nm.

The chemically-acting radiation of the invention is preferably coherent laser beam (having uniform phase and wavelength). As the laser to be used herein there may be used any of solid laser, semiconductor laser, gas laser and liquid laser. Preferred examples of laser beam include YAG laser second harmonic having a wavelength of 532 nm, YAG laser third harmonic having a wavelength of 355 nm, GaN laser having a wavelength of from about 405 to 415 nm, Ar ion laser having a wavelength of from 488 nm or 515 nm, He-Ne laser having a wavelength of 632 nm to 633 nm, Kr ion laser having a wavelength of 647 nm, ruby laser having a wavelength of 694 nm, and He-Cd laser having a wavelength of 636 nm, 634 nm, 538 nm, 534 nm and 442 nm.

Further, pulse laser on the order of nanosecond or picosecond is preferably used.

In the case where the hologram recording material of the invention is used as an optical recording medium, YAG laser second harmonic having a wavelength of 532 nm or GaN laser having a wavelength of from about 405 to 415 nm is preferably used.

The wavelength of the light beam for use in hologram reproduction is preferably the same as or longer than, more preferably the same as that of the light beam for use in hologram exposure (recording).

The hologram recording material of the invention which has been subjected to hologram exposure may be subjected to fixing by either or both of light and heat.

In the case where the hologram recording material of the invention comprises an acid proliferator or base proliferator, it is particularly preferred that fixing be carried out by heating to cause the acid proliferator or base proliferator to act effectively.

In the case of light fixing, the hologram recording material is entirely irradiated with ultraviolet ray or visible light (non-interference exposure). Preferred examples of the light employable herein include visible light laser, ultraviolet laser, carbon arc, high voltage mercury vapor lamp, xenon lamp, metal halide lamp, fluorescent lamp, tungsten lamp, LED, and organic EL.

In the case of heat fixing, fixing is preferably effect at a temperature of from 40°C to 160°C, more preferably from 60°C to 130°C.

In the case where both light fixing and heat fixing are effect, light and heat may be applied at the same time or separately.

The refractive index modulation during recording of interference band is preferably from 0.00001 to 0.5, more preferably from 0.0001 to 0.3. It is preferred that the more the thickness of the hologram recording material is, the less is the refractive index modulation. It is preferred that the less the thickness of the hologram recording material is, the more is the refractive index modulation.

The (relative) diffraction efficiency $\eta$ of a hologram recording material is given by the following equation:

$$\eta = Idiff/Io \qquad \text{(equation 1)}$$

where Io is the intensity of transmitted light which is not diffracted; and Idiff is the intensity of light which is diffracted (transmitted type) or reflected (reflected type). The diffraction efficiency may range from 0% to 100%, preferably 30%

or more, more preferably 60% or more, most preferably 80% or more.

The sensitivity of a hologram recording material is normally represented by exposure per unit area ($mJ/cm^2$). The less this value is, the higher is the sensitivity. The exposure at which the sensitivity is defined differs from literature or patent to literature or patent. In some cases, the exposure at which recording (refractive index modulation) begins is defined as sensitivity. In other cases, the exposure at which the maximum diffraction efficiency (refractive index modulation) is given is defined as sensitivity. In further cases, the exposure at which half the maximum diffraction efficiency is given is defined as sensitivity. In still further cases, the exposure at which the gradient of diffraction efficiency relative to exposure E becomes maximum is defined as sensitivity.

According to Kugelnick's theoretical equation, the refractive index modulation $\Delta n$ at which a certain diffraction efficiency is given is inversely proportional to the thickness d. In other words, the sensitivity at which a certain diffraction efficiency is given differs with thickness. Thus, the more the thickness d is, the less is the required refractive index modulation $\Delta n$. Accordingly, the sensitivity cannot be unequivocally compared unless the conditions such as thickness are uniform.

In the invention, sensitivity is defined by "exposure at which half the maximum diffraction efficiency is given ($mJ/cm^2$)". The sensitivity of the hologram recording material of the invention is preferably 1 $J/cm^2$ or less, more preferably 500 $mJ/cm^2$ or less, even more preferably 200 $mJ/cm^2$ or less, most preferably 100 $mJ/cm^2$ or less, if the thickness is from about 10 $\mu m$ to 200 $\mu m$.

In the case where the hologram recording material of the invention is used in holographic memory as an optical recording medium, it is preferred that many two-dimensional digital data (referred to as "signal light") be recorded using a spatial light modulation element (SLM) such as DMD and LCD. Recording is preferably accomplished by multiplexed recording to raise the recording density. Examples of multiplexed recording methods include angular multiplexed, phase multiplexed, wavelength multiplexed and shift multiplexed recording methods. Preferred among these multiplexed recording methods are angular multiplexed recording and shift multiplexed recording. In order to read reproduced three-dimensional data, CCD or CMOS is preferably used.

In the case where the hologram recording material of the invention is used in holographic memory as an optical recording medium, it is essential that multiplexed recording be effected to enhance the capacity (recording density). In this case, multiplexed recording involving preferably 10 or more times, more preferably 50 times or more, most preferably 100 times or more of recording jobs is performed. More preferably, any multiplexed recording can be effected always at a constant exposure to simplify recording system and enhance S/N ratio.

In the case where the hologram recording material of the invention is used as an optical recording medium, the hologram recording material is preferably stored in a light-screening cartridge during storage. It is also preferred that the hologram recording material be provided with a light filter capable of cutting part of wavelength range of ultraviolet ray, visible light and infrared ray other than recording light and reproduced light on the surface or back surface or on the both surfaces thereof.

In the case where the hologram recording material of the invention is used as an optical recording medium, the optical recording medium may be in the form of disc, card or tape or in any other form.

The various hologram recording methods of the invention and various components of the hologram recording material allowing these recording methods will be further described hereinafter.

1) Recording of interference band by polymerization reaction

This recording process preferably involves the use of at least a sensitizing dye, a polymerization initiator, a polymerizable compound and a binder wherein the polymerizable compound and the binder have different refractive indexes and allows the sensitizing dye to absorb light to cause photopolymerization which makes the composition ratio of the polymerizable compound to the binder different from the bright interference area to the dark interference area, whereby the recording of an interference band by refractive index modulation is effected.

Firstly, the sensitizing dye of the invention which absorbs light during hologram exposure to generate excited state will be further described hereinafter.

The sensitizing dye of the invention preferably absorbs any of ultraviolet ray, visible light and infrared ray having a wavelength of from 200 nm to 2,000 nm, more preferably ultraviolet ray or visible light having a wavelength of from 300 to 700 nm, even more preferably visible light having a wavelength of from 400 to 700 nm to generate excited state.

The sensitizing dye of the invention contains at least one metal complex dye. In the invention, the metal complex dye is preferably a metal complex dye which shows absorption at a longer wavelength than ligand when complexed. The metal complex dye of the invention is preferably a metalocene dye.

The metal complex dye which is a metalocene dye is preferably represented by the general formula (1).

In the invention, in the case where a specific portion is referred to as "group", it means that the portion may or may not be substituted by one or more (many as possible) substituents unless otherwise specified. For example,

"alkyl group" means a substituted or unsubstituted alkyl group.

In the case where a specific portion is referred to as "ring" or "group" includes "ring", it means that the portion may be monocyclic or fused ring or may or may not be substituted.

For example, "aryl group" may be a phenyl group, naphthyl group or substituted phenyl group.

In the general formula (1), $M_1$ represents a metal atom, preferably Fe, Ru, Os, Ti, Zn, Ni or Cu, more preferably Fe, Ru or Ti, even more preferably Fe or Ru, most preferably Fe. In other words, the metalocene dye is preferably a ferrocene derivative.

In the general formula (1), $R_1$ and $R_2$ each independently represent a substituent. Preferred examples of the substituent include alkyl groups (preferably alkyl group having from 1 to 20 carbon atoms such as methyl, ethyl, n-propyl, isopropyl, n-butyl, n-pentyl, benzyl, 3-sulfopropyl, 4-sulfobutyl, carboxymethyl, 2-carboxyethyl, hydroxymethyl, 2-hydroxyethyl, acetyloxymethyl, methoxymethyl, cyanomethyl, 2-methoxycarbonyletyl), alkenyl groups (preferably alkenyl group having from 2 to 20 carbon atoms such as vinyl, allyl, 3-butenyl and 1,3-butadienyl), cycloalkyl groups (preferably cycloalkyl group having from 3 to 20 carbon atoms such as cyclopentyl and cyclohexyl), aryl groups (preferably aryl group having from 6 to 20 carbon atoms such as phenyl, 2-chlorophenyl, 4-methoxyphenyl, 3-methylphenyl and 1- naphthyl), heterocyclic groups (preferably heterocyclic group having from 1 to 20 carbon atoms such as pyridyl, chenyl, furyl, thiazolyl, imidazolyl, pyrazolyl, pyrrolidino, piperidino, morpholino), alkinyl groups (preferably having from 2 to 20 carbon atoms such as ethinyl, 2-propinyl, 1,3-butadinyl and 2-phenylethinyl), halogen atoms (e.g., F, Cl, Br, I), amino groups (preferably amino group having from 0 to 20 carbon atoms such as amino, dimethylamino, diethylamino, dibutylamino and anilino), cyano groups, nitro groups, hydroxyl groups, mercapto groups, carboxyl groups, sulfo groups, phosphonic acid groups, acyl groups (preferably acyl group having from 1 to 20 carbon atoms such as acetyl, benzoyl, salicyloyl and pivaloyl), formyl groups, alkoxy groups (preferably alkoxy group having from 1 to 20 carbon atoms such as methoxy, butoxy and cyclohexyloxy), aryloxy groups (preferably aryloxy group having from 6 to 26 carbon atoms such as phenylthio and 4-chlorophenyl thio), alkylsulfonyl groups (preferably alkylsulfonyl group having from 1 to 20 carbon atoms such as methane sulfonyl and butanesulfonyl), arylsulfonyl groups (preferably arylsulfonyl group having from 6 to 20 carbon atoms such as benzenesulfonyl and paratoluenesulfonyl), sulfamoyl groups (preferably sulfamoyl group having from 0 to 20 carbon atoms such as sulfamoyl, N-methylsulfamoyl and N-phenylsulfamoyl), carbamoyl groups (preferably carbamoyl group having from 1 to 20 carbon atoms such as carbamoyl, N-methylcarbamoyl, N,N-dimethylcarbamoyl and N-phenylcarbamoyl), acylamino groups (preferably acylamino group having from 1 to 20 carbon atoms such as acetylamino and benzoylamino), imino groups (preferably imino group having from 2 to 20 carbon atoms such as phthalimino), acyloxy groups (preferably acryloxy group having from 1 to 20 carbon atoms such as acetyloxy and benzoyloxy), alkoxycarbonyl groups (preferably alkoxycarbonyl group having from 2 to 20 carbon atoms such as methoxycarbonyl and phenoxycarbonyl), and carbamoylamino groups (preferably carbamoylamino group having from 1 to 20 carbon atoms such as carbamoylamino, N-methylcarbamoylamino and N-phenylcarbamoylamino. More desirable among these substituents are alkyl groups, alkenyl groups, aryl groups, carboxyl groups, halogen atoms, acyl groups, formyl groups, alkoxy groups, carbamoyl groups, and alkoxycarbonyl groups.

In the general formula (I), a1 and a2 each independently represent an integer of from 0 to 5, preferably 0 or 1, more preferably 0. When a1 and a2 each are 2 or more, the plurality of $R_1$'s and $R_2$'s each may be the same or different and each may be connected to each other to form a ring. Preferred examples of the ring thus formed include benzene ring, and cyclohexane ring.

In the general formula (I), $L_1$ represents a ligand which can be bonded to $M_1$. $L_1$ may be a monovalent or divalent ligand.

Preferred examples of the ligand represented by $L_1$ include unidentate or bidentate ligands formed by groups or atoms selected from the group consisting of acyloxy groups (preferably acyloxy group having from 1 to 20 carbon atoms such as acetyloxy group, benzoyloxy group, salicylic acid group, glycyl group, N,N-dimethylglycyl group, oxalylene group (-OC(O)C(O)O-)), acylthio groups (preferably acylthio group having from 1 to 20 carbon atoms such as acetylthio group and benzoylthio group), thioacyloxy groups (preferably thioacyloxy group having from 1 to 20 carbon atoms such as thioacetyloxy group ($CH_3C(S)O-$)), thioacylthio groups (preferably thioacylthio group having from 1 to 20 carbon atoms such as thioacetylthio group ($CH_3C(S)S-$)), thiobenzoylthio groups (e.g., PhC(C)S-), acylaminooxy groups (preferably acylaminooxy group having from 1 to 20 carbon atoms such as N-methylbenzoylaminooxy group ($PhC(O)N(CH_3)O-$) and acetylaminooxy group ($CH_3C(O)NHO-$)), acetylaminooxy groups (e.g., $CH_3C(O)NHO-$), thiocarbamate groups (preferably thiocarbamate group having from 1 to 20 carbon atoms such as N,N-diethylthiocarbamate group), dithiocarbamate groups (preferably dithiocarbamate group having from 1 to 20 carbon atoms such as N- phenyldithiocarbamate group, N,N-dimethyldithiocarbamate group, N,N-diethyldithio carbamate group and N,N-dibenzyldithiocarbamate group), thiocarbonate groups (preferably thiocarbonate group having from 1 to 20 carbon atoms such as ethylthiocarbonate group), dithiocarbonate groups (preferably dithiocarbonate group having from 1 to 20 carbon atoms such as ethyldimethylcarbonate group ($C_2H_5OC(S)S-$)), trithiocarbonate groups (preferably trithiocarbonate group having from 1 to 20 carbon atoms such as ethyltrithiocarbonate group ($C_2H_SSC(S)S-$)), acyl groups

(preferably acyl group having from 1 to 20 carbon atoms such as acetyl group and benzoyl group), thiocyanate groups, isothiocyanate groups, cyanate groups, isocyanate groups, cyano groups, alkylthio groups (preferably alkylthio group having from 1 to 20 carbon atoms such as methanethio group and ethylenedithio group), arylthio groups (preferably arylthio group having from 6 to 20 carbon atoms such as benzenethio group and 1,2-phenylenedithio group), alkoxy groups (preferably alkoxy group having from 1 to 20 carbon atoms such as methoxy group) and aryloxy groups (preferably aryloxy group having from 6 to 20 carbon atoms such as phenoxy group and quinoline-8-hydroxyl group), and ligands formed by halogen atoms (preferably chlorine atom, bromine atom or iodine atom), dialkylketones (preferably dialkylketone group having from 3 to 20 carbon atoms such as acetone ($(CH_3)_2CO\cdots$) (in which ... represents coordinate bond), 1,3-diketones (preferably 1,3-diketone group having from 3 to 20 carbon atoms such as acetylacetone ($CH_3C(O\text{-})CH{=}C(O\cdot\cdot)CH_3$) and trifluoroacetylacetone ($CF_3C(O\text{-})CH{=}C(\cdots)CH_3$), dipivaloylmethane ($t\text{-}C_4H_9C(O\text{-})CH{=}C(O\cdots)C_4H_9\text{-}t$), dibenzoylmethane (phC(O-)CH=C(O···)ph) and 3- chloroacetylacetone ($CH_3C(O\text{-})CCl{=}C(O\cdots)CH_3$)), carbonyl (···CO) or carbonamides (preferably carbonyl(···CO) or carbonamide group having from 1 to 20 carbon atoms such as $CH_3N{=}C(CH_3)O\text{-}$ and -OC(=NH)-C(=NH)O-), thiocarbonamides (preferably thiocarbonamide having from 1 to 20 carbon atoms such as $CH_3N{=}C(CH_3)S\text{-}$) and thioureas (preferably thiourea having from 1 to 20 carbon atoms such as $NH(\cdots){=}C(S\text{-})NH_2$, $CH_3NH(\cdots){=}C(S\text{-})NHCH_3$ and $(CH_3)_2NH\text{-}C(S\cdots)N(CH_3)_2$).

Desirable among these ligands represented by $L_1$ are ligands formed by groups selected from the group consisting of acyloxy groups, thioacylthio groups, acylaminooxy groups, dithiocarbamate groups, dithiocarbonate groups, trithiocarbonate groups, thiocyanate groups, isothiocyanate groups, cyanate groups, isocyanate groups, cyano groups, alkylthio groups, arylthio groups, alkoxy groups and aryloxy groups and ligands formed by halogen atoms, carbonyl groups, 1,3-diketone groups or thiourea groups. More desirable among these ligands are ligands formed by groups selected from the group consisting of acyloxy groups, acylaminooxy groups, dithiocarbamate groups, thiocyanate groups, isothiocyanate groups, cyanate groups, isocyanate groups, cyano groups and arylthio groups and ligands formed by halogen atoms, 1,3-dietone groups or thiourea groups. Even more desirable among these ligands are ligands formed by dithiocarbamate groups, thiocyanate groups, isothiocyanate groups, cyanate groups, isocyanate groups, halogen atoms or 1,3-diketone groups.

The suffix a3 represents an integer of from 0 to 6, preferably from 0 to 2, more preferably 0.

The metal complex dye of the invention which is a metalocene dye is most preferably ferrocene.

The metal complex dye of the invention is also preferably a metal complex dye represented by any of the general formulae (II-1) to (II-3).

In the general formula (II-1), $M_2$ represents a metal, preferably a transition metal, more preferably Cr, Mn, Fe, Co, Ni, Cu, Zn, Mo, Ru, Rh, Pd, Ag, W, Re, Os, Ir, Pt or Au, even more preferably Fe, Co, Ni, Cu, Mo, Ru, Rh, W, Re, Os, Ir or Pt, still more preferably Fe, Cu, Ru or Pt, most preferably Ru.

In the general formula (II-1), $Z_1$ and $Z_2$ each independently represent a non-metal atom group which can form a 5- or 6-membered heterocyclic group. Preferred examples of the ring thus formed include pyridine ring, pyrimidine ring, pyridazine ring, pyrazine ring, triazine ring, pyrrole ring, imidazole ring, triazole ring, thiazole ring, oxazole ring, thiadiazole ring, and oxadiazole ring. These rings may be further condensed with benzene ring, pyridine ring or the like.]

More desirable among the groups thus formed are pyridine ring and imidazole ring. Most desirable among these groups is pyridine ring.

These rings may further have substituents provided thereon. Preferred examples of the substituents include those exemplified with reference to $R_1$. Preferred among these substituents are alkyl groups, alkenyl groups, aryl groups, alkoxy groups, amino groups, halogen atoms, nitro groups, sulfo groups, carboxyl groups, phosphoryl groups, alkoxycarbonyl groups, and carbamoyl groups.

Further, the substituents on $Z_1$ and the substituents on $Z_2$ may be connected to each other to form a ring. Examples of the ring thus formed include benzene ring, pyridine ring, and cyclohexadiene ring. In this case, it is preferred that the compound of the general formula (II-1) generally form a phenathroline ring.

In the general formula (II-1), $L_2$ represents a ligand which may be either one-coordinate or two-coordinate. Preferred examples of the ligand $L_2$ include those exemplified with reference to $L_1$. The suffix a4 represents an integer of from 1 to 3, preferably 2 or 3, most preferably 3. The suffix a5 represents an integer of from 0 to 4, preferably from 0 to 2, most preferably 0. CI represents an ion required to neutralize charge. Examples of CI which is a cation include proton, lithium ion, sodium ion, potassium ion, magnesium ion, calcium ion, triethylammonium ion, diethyl(i-propyl) ammonium ion, pyridinium ion, 1-ethylpyridinium ion, tetrabutyl ammonium ion, and tetramethyl ammonium ion. Examples of CI which is an anion include halogen anions (e.g., chlorine ion, bromine ion, fluorine ion, iodine ion), arylsulfonic acid ions (e.g., paratoluenesuofonic acid ion, tetrafluorosulfonic acid ion), alkylsulfonic acid ions (e.g., methanesulfonic acid ion, trifluoromethane sulfonic acid ion), alkylsulfuric acid ions (e.g., methylsulfuric acid ion), sulfuric acid ions, carboxylic acid ions (e.g., acetic acid ion, trifluoroacetic acid ion), perchloric acid ions, tetrafluoroboric acid ions, hexafluoroboric acid ions, and hexafluoroantimonic acid ions. The suffix y represents an integer required to neutralize charge.

In the general formula (II-2), $M_2$, $L_2$, a5, CI and y are as defined in the general formula (II-1). $Z_3$ and $Z_4$ each

independently represent a non-metal atom group which can form a 5- or 6-membered heterocyclic group. Preferred examples of the non-metal atom group include those exemplified with reference to $Z_1$ and $Z_2$. The suffix a6 represents an integer of 1 or 2, preferably 2.

In the general formula (II-3), $Z_1$, $L_2$, a5, CI and y are as defined in the general formula (II-1). $M_3$ represents a metal, preferably a transition metal, more preferably Cr, Mn, Fe, Co, Ni, Cu, Zn, Mo, Ru, Rh, Pd, Ag, W, Re, Os, Ir, Pt or Au, even more preferably Ru, Rh, W, Re, Os, Ir or Pt, still more preferably Ir or Pt.

$R_3$ represents a substituent. Preferred examples of the substituent include those exemplified with reference to substituents on $Z_1$.

The suffix a7 represents an integer of from 0 to 4, preferably 0 or 1, more preferably 0. When a7 is 2 or more, the plurality of $R_3$'s may be the same or different and may be connected to each other to form a ring. Preferred examples of the ring thus formed include benzene ring, and pyridine ring.

The metal complex dye represented by any of the general formulae (II-1) to (II-3) is preferably an MLCT (Metal to Ligand Charge Transfer) type metal complex dye. The metal complex dye is preferably a complex dye.

In the case where the metal complex dye of the invention is used as a sensitizing dye, the hologram recording material of the invention is preferably used for optical recording medium or holographic memory. In holographic memory, multiplexed recording comprising more than 50 times, preferably 100 times of recording jobs is effected to obtain as much recoding density as possible. In this case, the thickness of the hologram recording material normally needs to be at least 100 μm, preferably at least 500 μm to generate severe angle dependence under severe Bragg conditions. In order to perform recording of interference band on the entire surface of the hologram recording material, the hologram recording light is preferably transmitted by the hologram recording material by from not smaller than 10% to not greater than 99%, more preferably from not smaller than 20% to not greater than 90%.

Accordingly, in the case where an ordinary organic sensitizing dye having a high molar absorptivity is used, it is necessary that the amount of the sensitizing dye be drastically reduced to allow the recording light to be transmitted by such a thick hologram recording material. As a result, the recording sensitivity is drastically lowered to disadvantage. Therefore, it is preferred from the standpoint of sensitivity and multiplexed recording properties that the sensitizing dye to be used in holographic memory have as low ε as possible and the amount of the sensitizing dye be reduced as much as possible. In this respect, the aforementioned metal complex dye having low ε and a high sensitizing capacity is very advantageous. However, there have been found no literatures and patents which refer to these metal complex dyes.

It is further preferred that recording be effected at a wavelength of not greater than one fifth, more preferably one tenth of λmax of the sensitizing dye rather than in the vicinity of λmax of the sensitizing dye.

From this standpoint of view, the metal complex dye which is a sensitizing dye of the invention preferably exhibits a molar absorptivity of from not smaller than 1 to not greater than 5,000, more preferably from not smaller than 1 to not greater than 2,000, most preferably from not smaller than 5 to not greater than 1,000 at hologram recording wavelength.

Further, the molar absorptivity of the metal complex dye which is a sensitizing dye of the invention at hologram recording wavelength is preferably one fifth, more preferably one tenth of that at λmax.

In general, the radical cation or anion produced from an organic dye when it causes electron movement sensitization of a polymerization initiator or the like is so unstable that it has a reduced life. Thus, an organic dye rapidly decomposes during multiplexed recording and is normally unsuitable multiplexed recording.

From the aforementioned standpoint of view, when the radical cation or anion of sensitizing dye is more stable, it is more favorable for sensitivity and multiplexed recording properties. In this respect, metal complex dyes such as ferrocene and Ru complex dye can form an extremely stable radical cation or anion and thus are favorable. However, there have been found no literatures and patents which refer to these metal complex dyes.

Specific examples of the metal complex dye which is a sensitizing dye of the invention will be given below, but the invention is not limited thereto.

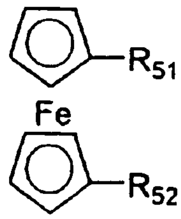

| | $R_{51}$ | $R_{52}$ |
|---|---|---|
| S-1 | H | H |
| S-2 | $-CHO$ | H |
| S-3 | $-(CH_2)_2OH$ | H |
| S-4 | $-CH_2OH$ | H |
| S-5 | $-CH_2OCOCH_3$ | H |
| S-6 | $-CH_3$ | $-CH_3$ |
| S-7 | $-CH_3$ | H |
| S-8 | $-COOH$ | H |
| S-9 | $-CH_2COOH$ | H |
| S-10 | $-CH_2CH_2COOH$ | H |
| S-11 | $-COOCH_3$ | H |
| S-12 | $-CON(CH_3)_2$ | H |
| S-13 | $-CH_2CH_2COOCH_3$ | H |
| S-14 | $-CH_2OH$ | $-CH_2OH$ |
| S-15 | $-CH_2OCOCH_3$ | $-CH_2OCOCH_3$ |
| S-16 | $-CH_2CN$ | H |
| S-17 | 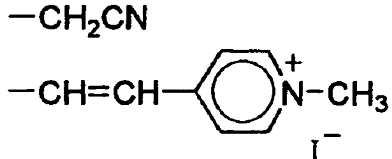 | H |
| S-18 | 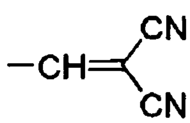 | H |
| S-19 | 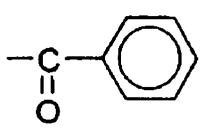 | H |

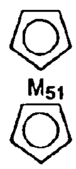

| | $M_{51}$ |
|---|---|
| S-20 | Ru |
| S-21 | Os |
| S-22 | Zn |
| S-23 | Ni |
| S-24 | Cu |

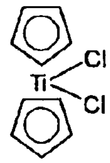

S-25

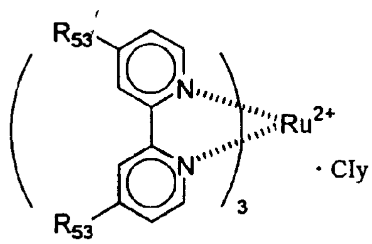

| | $R_{53}$ | Cly |
|---|---|---|
| S-26 | H | $(PF_6^-)_2$ |
| S-27 | H | $(Cl^-)_2$ |
| S-28 | H | $(CF_3SO_3^-)_2$ |
| S-29 | H | $(CF_3COO^-)_2$ |
| S-30 | H | $(BF_4^-)_2$ |
| S-31 | $-CH_3$ | $(PF_6^-)_2$ |
| S-32 | $-OCH_3$ | $(PF_6^-)_2$ |
| S-33 | $-N(CH_3)_2$ | $(PF_6^-)_2$ |
| S-34 | $-Cl$ | $(PF_6^-)_2$ |
| S-35 | $-NO_2$ | $(PF_6^-)_2$ |
| S-36 | $-SO_3^-$ | $\{N^{+}(C_4H_9)_4\}_4$ |
| S-37 | $-COO^-$ | $\{N^{+}(C_4H_9)_4\}_2$, $2H^+$ |
| S-38 | $-COOCH_3$ | $(PF_6^-)_2$ |
| S-39 | $-CONHCH_3$ | $(PF_6^-)_2$ |
| S-40 | 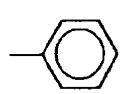 | $(PF_6^-)_2$ |

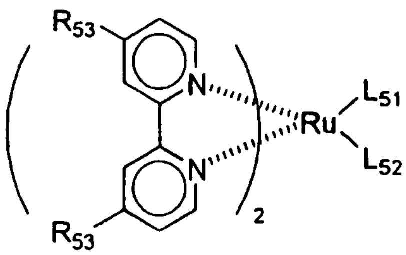 · CIy

| | $R_{53}$ | $L_{51}$, $L_{52}$ | CIy |
|---|---|---|---|
| S-41 | H | $-(NCS)_2$ | — |
| S-42 | $-COO^-$ | $-(NCS)_2$ | $\{\overset{+}{N}(C_4H_9)_4\}_2$, $2H^+$ |
| S-43 | H | 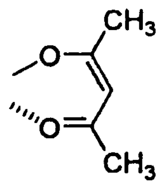 | $PF_6^-$ |
| S-44 | H | $-(Cl)_2$ | — |
| S-45 | H | $-(CN)_2$ | — |
| S-46 | H | 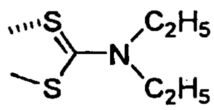 | $PF_6^-$ |
| S-47 | H | 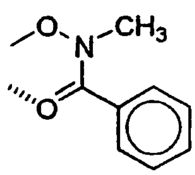 | $PF_6^-$ |
| S-48 | H | $-(NCO)_2$ | — |

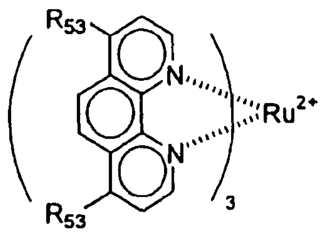 · CIy

| | $R_{53}$ | CIy |
|---|---|---|
| S-49 | H | $(PF_6^-)_2$ |
| S-50 | H | $(Cl^-)_2$ |
| S-51 | H | $(CF_3SO_3^-)_2$ |
| S-52 | H | $(CF_3COO^-)_2$ |
| S-53 | H | $(BF_4^-)_2$ |
| S-54 | $-CH_3$ | $(PF_6^-)_2$ |
| S-55 | $-COO^-$ | $\{\overset{+}{N}(C_4H_9)_4\}_2$, $2H^+$ |
| S-56 | $-COOCH_3$ | $(PF_6^-)_2$ |
| S-57 | 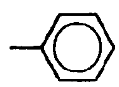 | $(PF_6^-)_2$ |

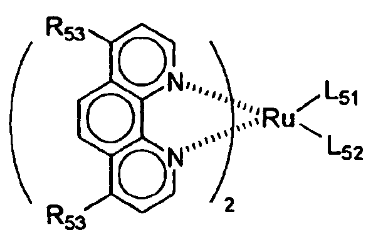 · CIy

| | $R_{53}$ | $L_{51}$, $L_{52}$ | CIy |
|---|---|---|---|
| S-58 | H | $-(NCS)_2$ | — |
| S-59 | $-COO^-$ | $-(NCS)_2$ | $\{\overset{+}{N}(C_4H_9)_4\}_2$, $2H^+$ |
| S-60 | H | 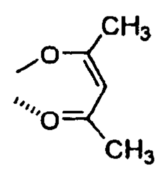 | $PF_6^-$ |
| S-61 | H | 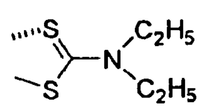 | $PF_6^-$ |
| S-62 | H | 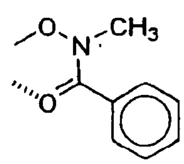 | $PF_6^-$ |

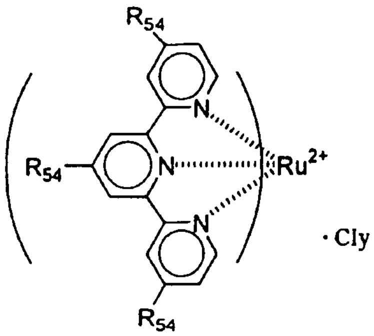

| | $R_{54}$ | Cly |
|---|---|---|
| S-63 | H | $(PF_6^-)_2$ |
| S-64 | $-C_2H_5$ | $(PF_6^-)_2$ |
| S-65 | $-COO^-$ | $\{\overset{+}{N}(C_4H_9)_4\}_2$, $2H^+$ |

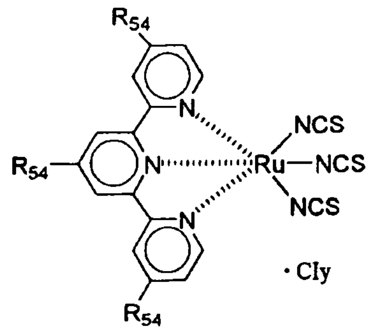

| | $R_{54}$ | Cly |
|---|---|---|
| S-66 | H | $\overset{+}{N}(C_4H_9)_4$ |
| S-67 | $-COOH$ | $\overset{+}{N}(C_4H_9)_4$ |

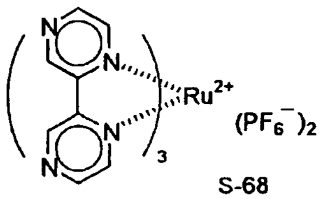

S-68

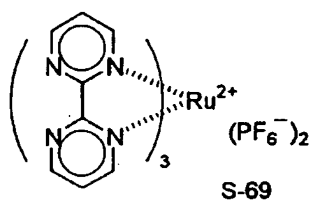

S-69

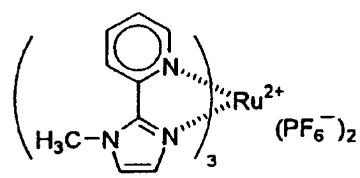

S-70

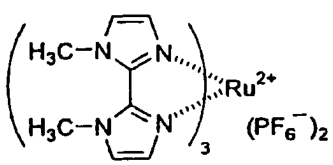

S-71

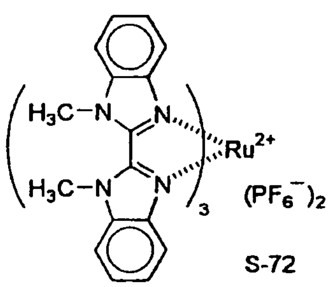

S-72

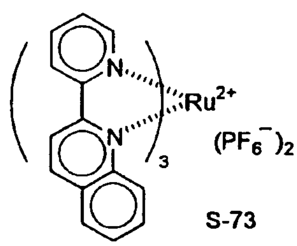

S-73

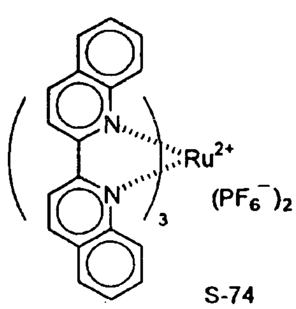

S-74

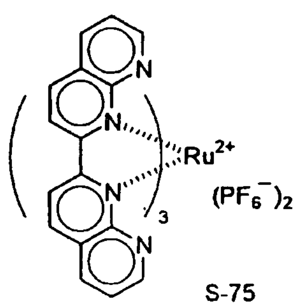

S-75

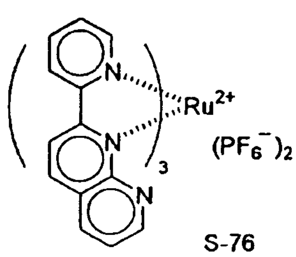

S-76

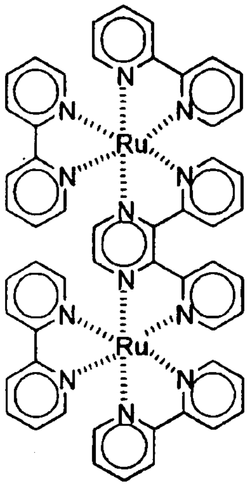

$\cdot (PF_6^-)_4$

S-77

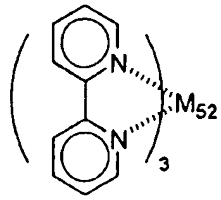

$\cdot$ Cly

| | $M_{52}$ | Cly |
|---|---|---|
| S-78 | $Fe^{2+}$ | $(PF_6^-)_2$ |
| S-79 | $Os^{2+}$ | $(PF_6^-)_2$ |
| S-80 | $Co^{3+}$ | $(PF_6^-)_3$ |
| S-81 | $Rh^{3+}$ | $(PF_6^-)_3$ |
| S-82 | $Ir^{3+}$ | $(PF_6^-)_3$ |
| S-83 | $Ni^{2+}$ | $(PF_6^-)_2$ |
| S-84 | $Zn^{2+}$ | $(PF_6^-)_2$ |

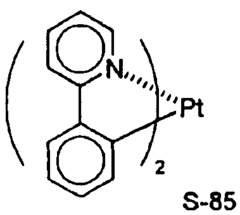

S-85

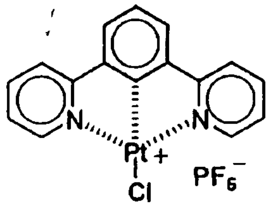

$PF_6^-$

S-86

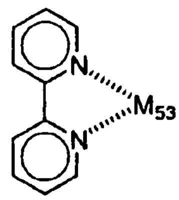

$(CO)_4$

| | $M_{53}$ |
|---|---|
| S-87 | Cr |
| S-88 | Mo |
| S-89 | W |

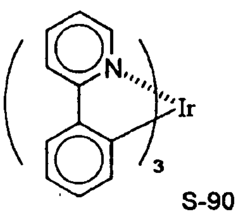

S-90

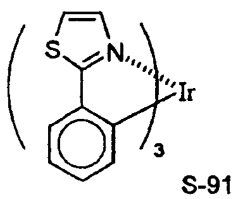

S-91

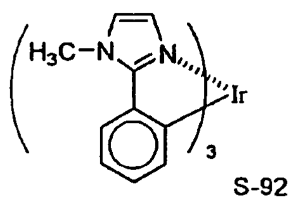

S-92

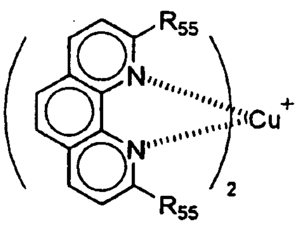

$PF_6^-$

| | $M_{55}$ |
|---|---|
| S-93 | 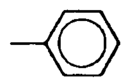 |
| S-94 | $-CH_3$ |

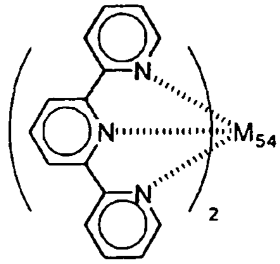

$\cdot$ Cly

| | $M_{54}$ | Cly |
|---|---|---|
| S-95 | $Co^{2+}$ | $(PF_6^-)_2$ |
| S-96 | $Cu^{2+}$ | $(PF_6^-)_2$ |
| S-97 | $Rh^{2+}$ | $(PF_6^-)_2$ |
| S-98 | $Fe^{2+}$ | $(PF_6^-)_2$ |
| S-99 | $Os^{2+}$ | $(PF_6^-)_2$ |

The sensitizing dye of the invention is commercially available or can be synthesized by any known method.

It is preferred that one of the polymerizable compound or the binder contain at least one aryl group, aromatic heterocyclic group, chlorine atom, bromine atom, iodine atom and sulfur atom and the other be free of these groups or atoms.

Preferred examples of the polymerization initiator include ketone-based, organic peroxide-based, trihalomethyl-substituted triazine-based, diazonium salt-based, diaryl iodonium salt-based, sulfonium salt- based, borate-based, diaryl iodonium-organic boron complex-based, sulfonium-organic boron complex-based, cationic sensitizing dye-organic boron complex-based, anionic sensitizing dye-onium salt complex-based, metal -allene complex-based and sulfonic acid ester-based radical polymerization initiators (radical generators), cationic polymerization initiators (acid generators) and radical polymerization-cationic polymerization initiators.

Specific preferred examples of the polymerization initiator, polymerizable compound and binder include those exemplified in Japanese Patent Application No. 2003-300057.

An acid proliferator is preferably used to enhance sensitivity. Preferred examples of the acid proliferator employable herein include those exemplified in Japanese Patent Application No. 2003-182849.

Further, an anionic polymerization initiator and a base generator (base generator) is preferably used. In this case, a base proliferator is preferably used to enhance sensitivity. Specific preferred examples of the base proliferator include those exemplified in Japanese Patent Application No. 2003-178083.

In the case where a radical polymerization initiator is used, the polymerizable compound to be polymerized preferably has an ethylenically-unsaturated group such as acryloyl group, methacryloyl group, styryl group and vinyl group. In the case where a cationic polymerization initiator or base generator is used, the polymerizable compound to be polymerized preferably has an oxirane ring, oxethanone ring or vinylether group.

Specific preferred examples of the polymerization initiator of the invention will be given below, but the invention is not limited thereto.

<Radical polymerization initiator (radical generator), cationic polymerization initiator (acid generator)>

I-1

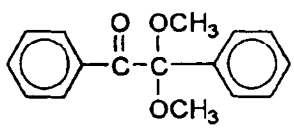

I-2

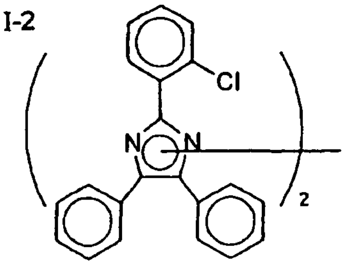

I-3

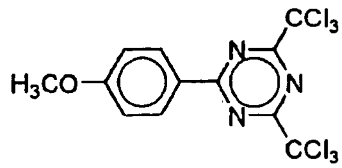

I-4

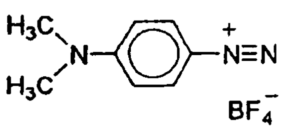

I-5

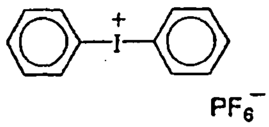

I-6

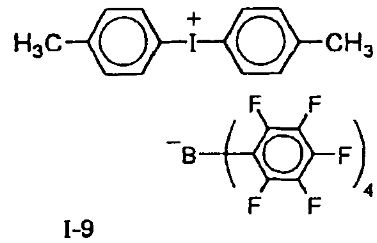

I-7

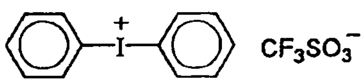

I-8

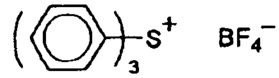

I-9

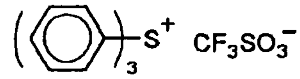

I-10

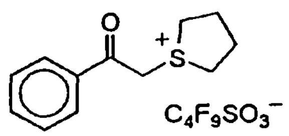

I-11

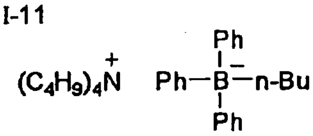

I-12

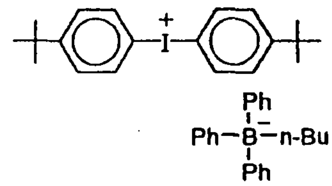

I-13

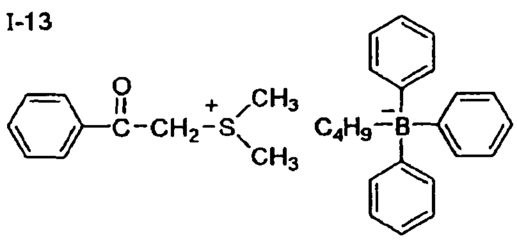

I-14

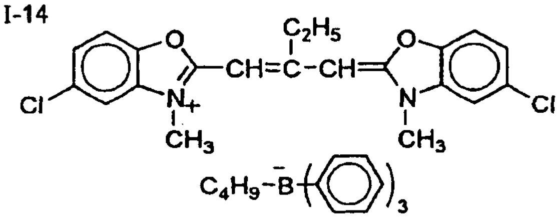

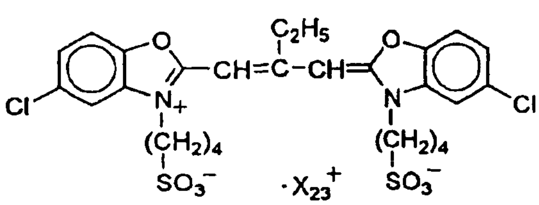

| | $X_{23}^{+}$ | |
|---|---|---|
| I-15 | 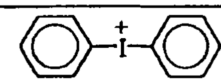 | (=C-1) |
| I-16 | 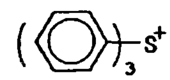 | (=C-2) |
| I-17 | 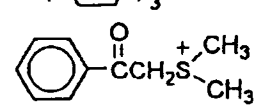 | (=C-3) |

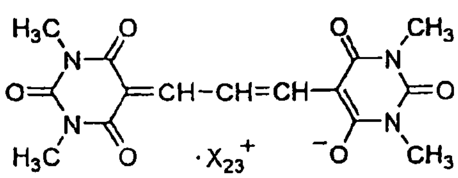

| | $X_{23}^{+}$ |
|---|---|
| I-18 | C-1 |
| I-19 | C-2 |
| I-20 | C-3 |

I-21

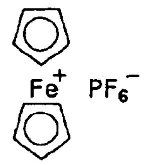

I-22

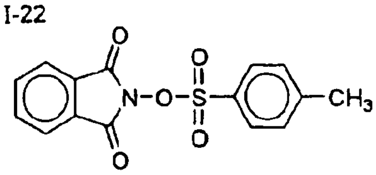

I-23

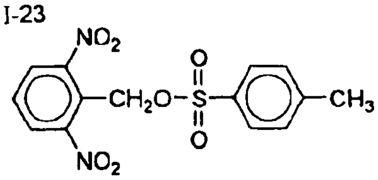

Anionic polymerization initiator (base generator)

PB-1

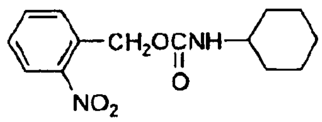

PB-2

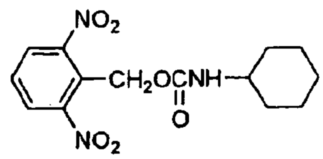

PB-3

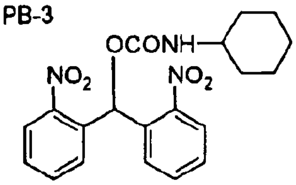

PB-4

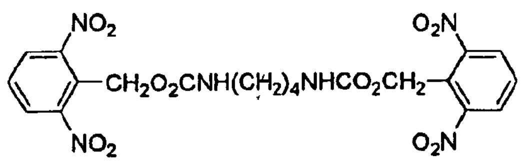

PB-5

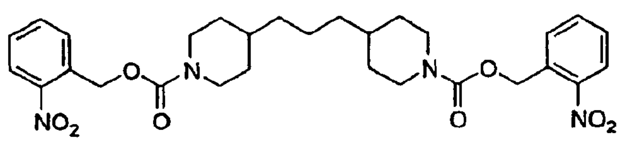

PB-6

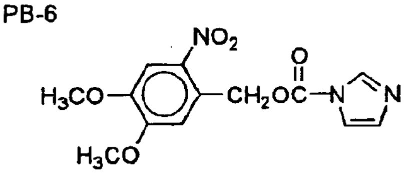

PB-7

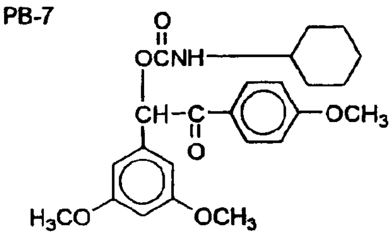

PB-8

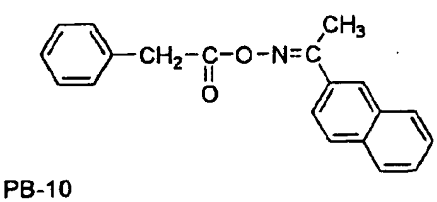

PB-9

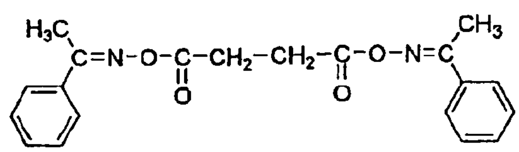

PB-10

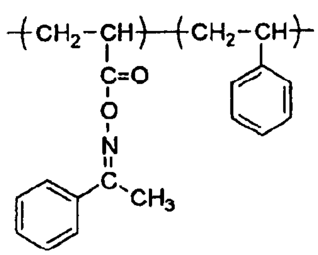

PB-11

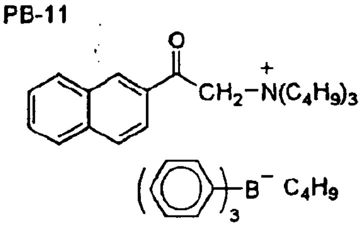

PB-12

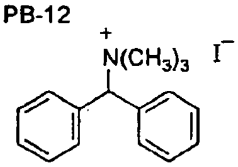

2) Recording of interference band by color development reaction

The term "color development reaction" as used herein is meant to indicate a reaction involving the change of absorption spectrum form or preferably either or both of the shift of λmax to longer wavelength and rise of ε in absorption spectrum in the range of ultraviolet ray, visible light and infrared ray having a wavelength of from 200 nm to 2,000 nm. The color development reaction preferably occurs at a wavelength of from 200 nm to 1,000 nm, more preferably from 300 nm to 900 nm.

In the case where recording involves color development reaction, the hologram recording material of the invention preferably contains at least:

1) A sensitizing dye which absorbs light upon hologram exposure to generate excited state; and
2) An interference band-recording component containing a dye precursor which can form a coloring material that has absorption at longer wavelength than in the original state and no absorption at hologram reproducing light wavelength, which interference band-recording component can undergo electron movement or energy movement from excited state of sensitizing dye to cause color development leading to refractive index modulation by which an interference band is recorded.

The refractive index of the dye rises in the range of from close to linear absorption maxima wavelength (λmax) to wavelength longer than linear absorption maxima wavelength (λmax), rises drastically in the range of from λmax to wavelength about 200 nm longer than λmax. In this wavelength range, some dyes show a refractive index of more than 2, as high as more than 2.5 in some cases. On the other hand, organic compounds which are not a dye, such as binder polymer, normally have a refractive index of from about 1.4 to 1.6.

It is thus made obvious that the color development of the dye precursor by hologram exposure makes it possible to fairly make not only a difference in absorbance but also a great difference in refractive index.

In the hologram recording material of the invention, the refractive index of the dye formed by the recording component preferably reaches maximum in the vicinity of laser wavelength at which reproduction is effected.

Preferred examples of the sensitizing dye include those exemplified above.

Preferred examples of the interference band- recording component include the following combinations. Specific preferred examples of these combinations include those described in Japanese Patent Application No. 2003-298936.

i) Combination of at least an acid-colorable dye precursor as dye precursor, an acid generator and optionally an acid proliferator

As the acid generator there may be used a diaryl iodonium salt, sulfonium salt or sulfonic acid ester, preferably the aforementioned acid generator (cationic polymerization initiator).

Preferred examples of the coloring material produced from the acid-colorable dye precursor include xanthene dyes, fluorane dyes, and triphenylmethane dyes. Particularly preferred examples of the acid-colorable dye precursor will be given below, but the invention is not limited thereto.

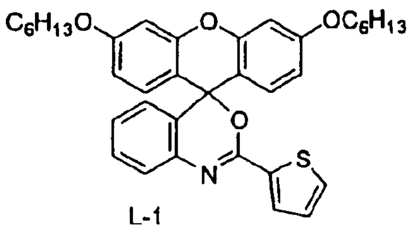

L-1

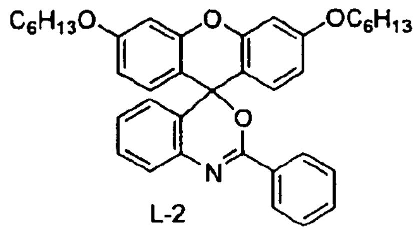

L-2

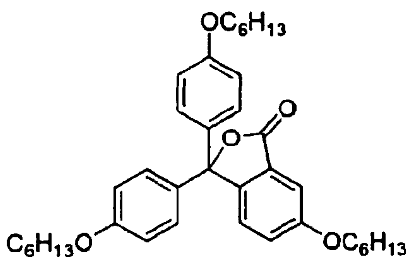

L-3

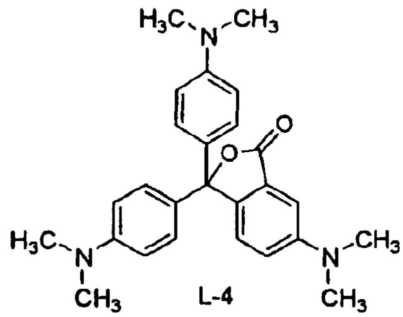

L-4

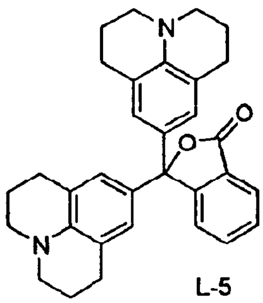

L-5

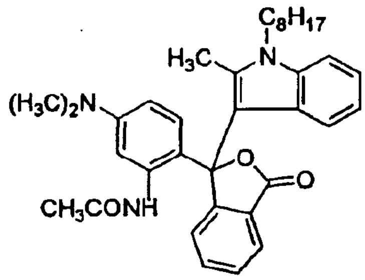

L-6

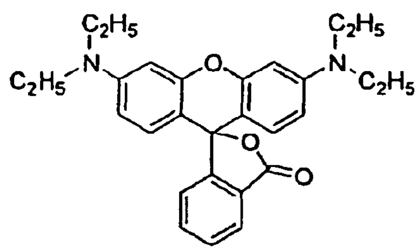

L-7

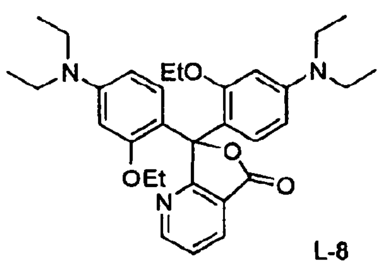

L-8

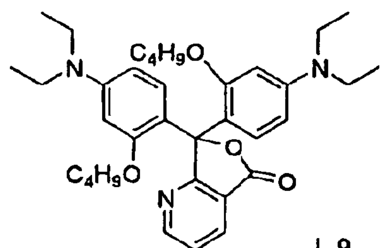

L-9

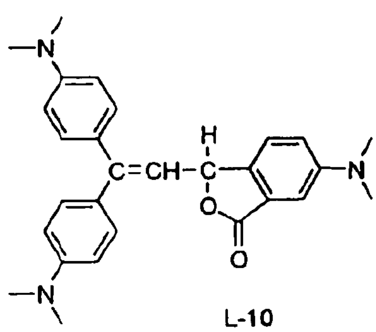

L-10

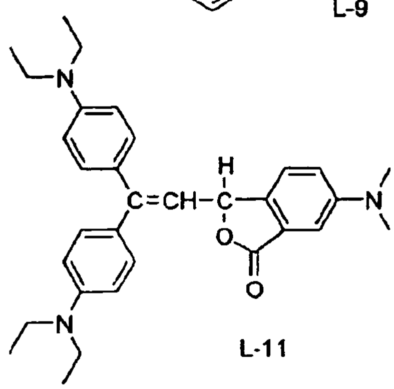

L-11

ii) Combination of at least a base-colorable dye precursor as dye precursor, a base generator and optionally a base proliferator

As the base generator there is preferably used the aforementioned base generator (anionic polymerization initiator). Examples of the base-colorable dye precursor include dissociative azo dyes, dissociative azomethine dyes,

dissociative oxonol dyes, dissociative xanthene dyes, dissociative fluorane dyes and dissociative triphenylmethane dyes in undissociated form.

Particularly preferred examples of the base- colorable dye precursor will be given below, but the invention is not limited thereto.

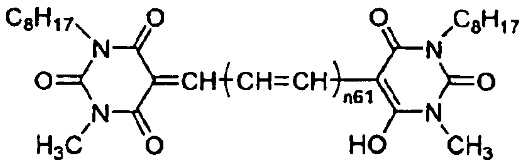

| | n61 |
|---|---|
| DD-1 | 1 |
| DD-2 | 2 |
| DD-3 | 3 |

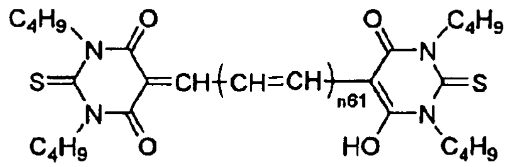

| | n61 |
|---|---|
| DD-4 | 0 |
| DD-5 | 1 |
| DD-6 | 2 |

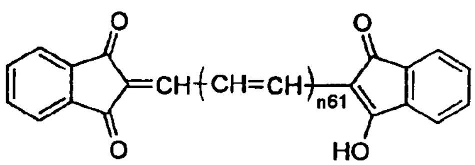

| | n61 |
|---|---|
| DD-7 | 0 |
| DD-8 | 1 |
| DD-9 | 2 |

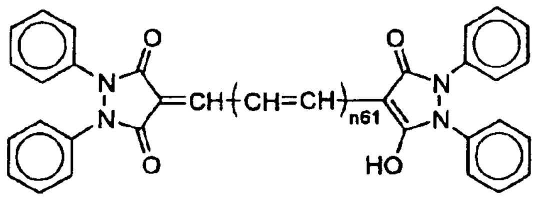

| | n61 |
|---|---|
| DD-10 | 0 |
| DD-11 | 2 |
| DD-12 | 3 |

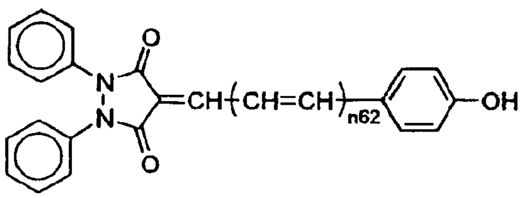

| | n62 |
|---|---|
| DD-13 | 0 |
| DD-14 | 1 |

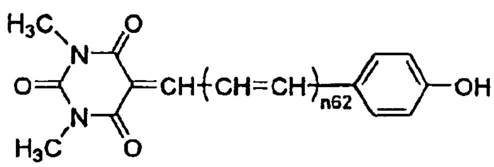

| | n62 |
|---|---|
| DD-15 | 0 |
| DD-16 | 1 |

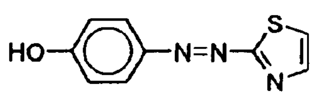

DD-17

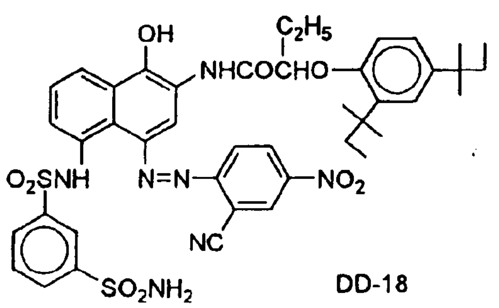

DD-18

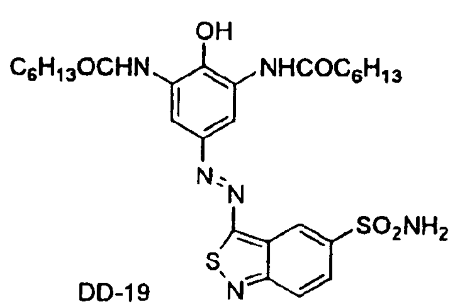

DD-19

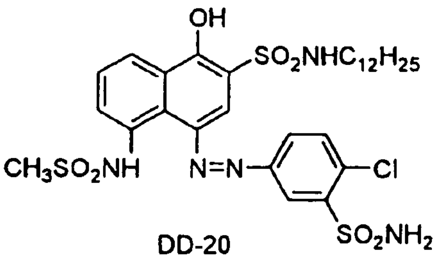

DD-20

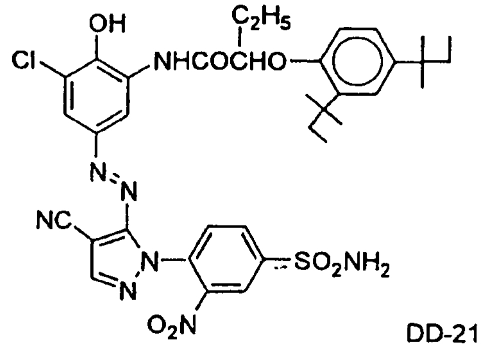

DD-21

DD-22

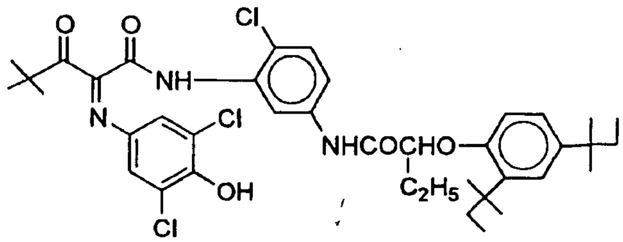

DD-23

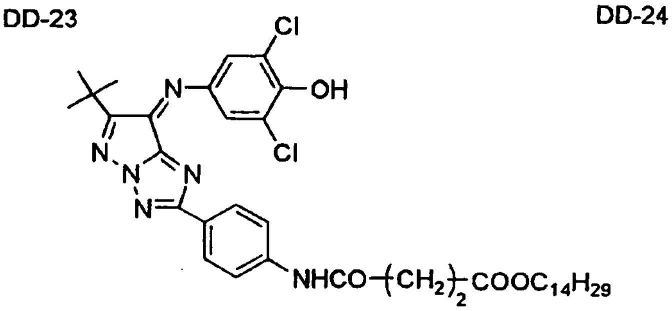

DD-24

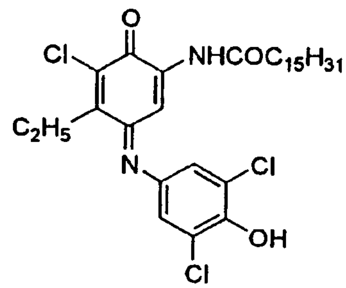

DD-25

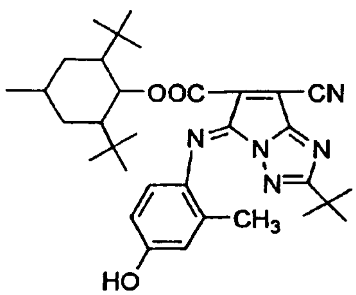

DD-26

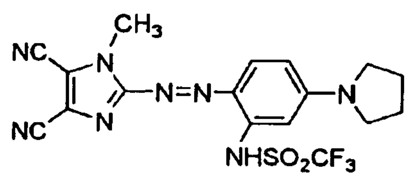

DD-27

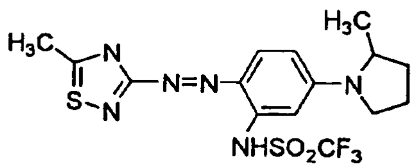

DD-28

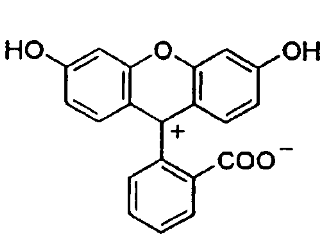

DD-29

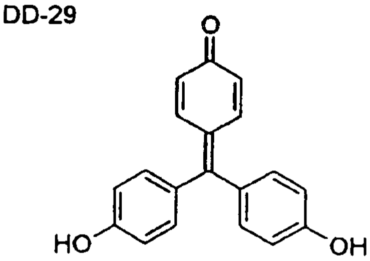

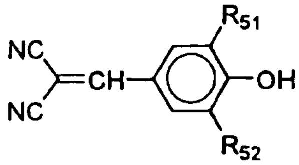

| | $R_{51}$ | $R_{52}$ |
|---|---|---|
| DD-30 | —H | —H |
| DD-31 | —Cl | —H |
| DD-32 | —Cl | —Cl |

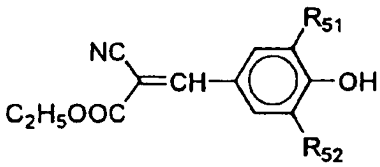

| | $R_{51}$ | $R_{52}$ |
|---|---|---|
| DD-33 | —H | —H |
| DD-34 | —Cl | —H |
| DD-35 | —Cl | —Cl |

iii) A compound having an organic compound moiety capable of severing covalent bond upon electron movement or energy movement from or to excited state of sensitizing dye and an organic compound moiety capable of forming a coloring material during covalent bonding and when released, which moieties being covalently bound, optionally combined with a base. Particularly preferred examples of such a combination will be given below, but the invention is not limited thereto.

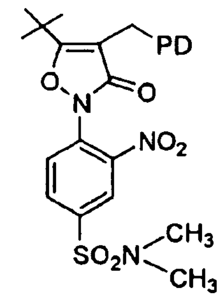

| | PD |
|---|---|
| E-1 | PD-1 |
| E-2 | PD-2 |
| E-3 | PD-21 |
| E-4 | PD-26 |
| E-5 | PD-9 |

| | PD |
|---|---|
| E-6 | PD-10 |
| E-7 | PD-12 |
| E-8 | PD-13 |
| E-9 | PD-16 |
| E-10 | PD-18 |

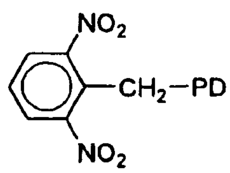

| | PD |
|---|---|
| E-11 | PD-21 |
| E-12 | PD-2 |
| E-13 | PD-26 |
| E-14 | PD-7 |
| E-15 | PD-8 |

| | PD |
|---|---|
| E-16 | PD-11 |
| E-17 | PD-14 |
| E-18 | PD-15 |
| E-19 | PD-17 |

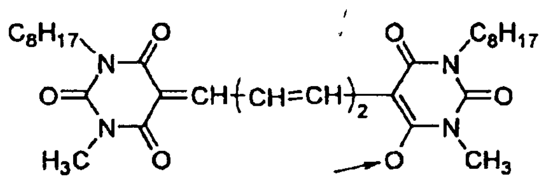

PD-1

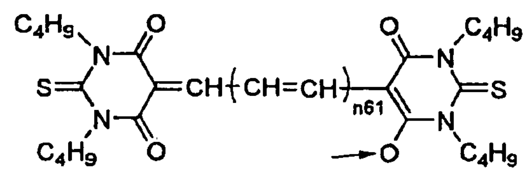

| | n61 |
|---|---|
| PD-2 | 0 |
| PD-3 | 1 |
| PD-4 | 2 |

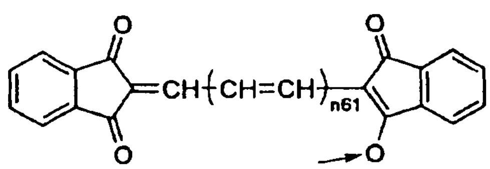

| | n61 |
|---|---|
| PD-5 | 0 |
| PD-6 | 2 |

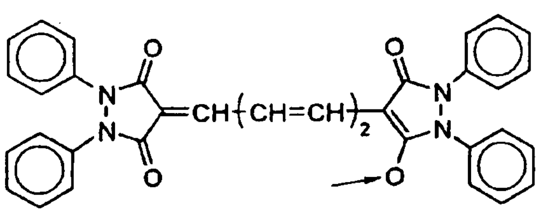

PD-7

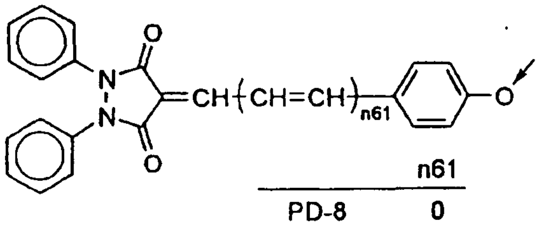

| | n61 |
|---|---|
| PD-8 | 0 |
| PD-9 | 1 |

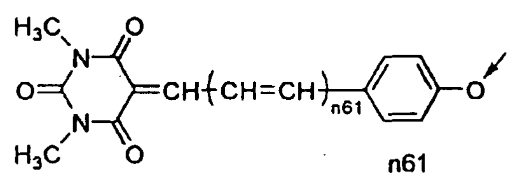

| | n61 |
|---|---|
| PD-10 | 0 |
| PD-11 | 1 |

PD-12

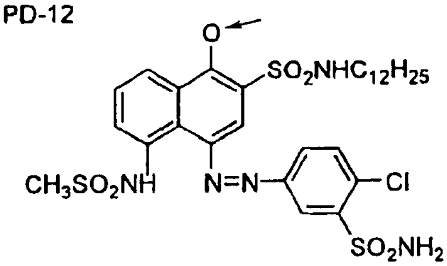

PD-13

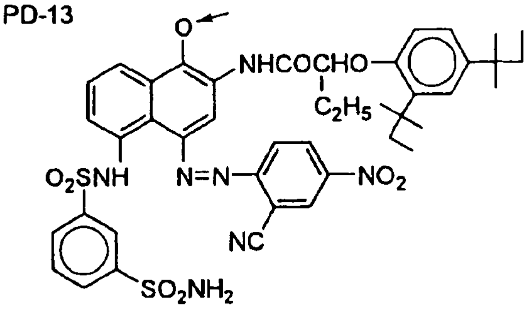

PD-14

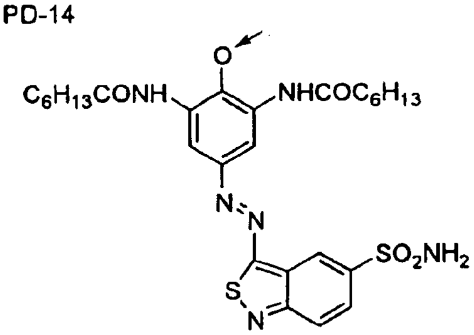

PD-15

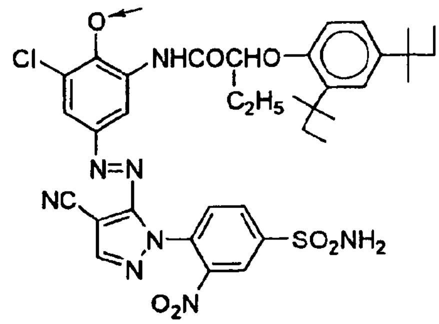

PD-16

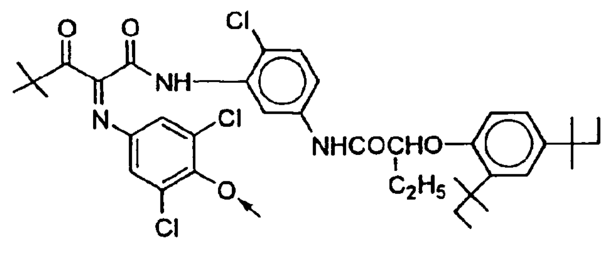

PD-17

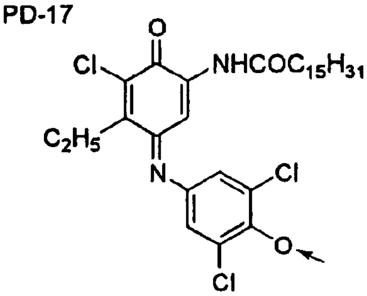

PD-18

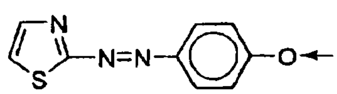

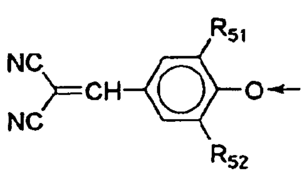

| | $R_{51}$ | $R_{52}$ |
|---|---|---|
| PD-19 | —H | —H |
| PD-20 | —Cl | —H |
| PD-21 | —Cl | —Cl |
| PD-22 | —Cl | $-COOC_2H_5$ |
| PD-23 | —Cl | —CN |

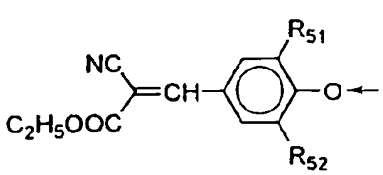

| | $R_{51}$ | $R_{52}$ |
|---|---|---|
| PD-24 | —H | —H |
| PD-25 | —Cl | —H |
| PD-26 | —Cl | —Cl |

iv) Compound capable of reacting upon electron movement from or to excited state of sensitizing dye to change absorption form. A so-called electrochromic compound is preferably used.

3) Recording of interference band by latent image color development-coloring material self-sensitized amplification color development reaction

This hologram recording method comprises at least a first step of forming a coloring material having no absorption at hologram reproducing light wavelength as a latent image by hologram exposure and a second step of irradiating the coloring material latent image with light beam having a wavelength different from hologram exposure wavelength at which the sensitizing dye exhibits a molar absorptivity of 5,000 or less to cause the self-sensitized amplification of the coloring material, whereby an interference band is recorded as refractive index modulation, which steps being effected in a dry process. This hologram recording method is advantageous in high speed writing properties, high S/N ratio reproducibility, etc.

The term "latent image" as used herein is meant to indicate that the refractive index difference formed after the second step is preferably one second or less (that is, magnification of 2 or more is preferably effected at the second step), more preferably one fifth or less, even more preferably one tenth or less, most preferably one thirtieth or less (that is, magnification of 5 or more, more preferably 10 or more, most preferably 30 or more is effected at the second step).

The second step preferably involves either or both of the irradiation with light and the application of heat, more preferably the irradiation with light. The irradiation with light preferably involves entire exposure (so-called solid exposure, blanket exposure or non-imagewise exposure). Preferred examples of the light source to be used herein include visible light laser, ultraviolet laser, infrared laser, carbon arc, high voltage mercury vapor lamp, xenon lamp, metal halide lamp, fluorescent lamp, tungsten lamp, LED, and organic EL. In order to irradiate the hologram recording material with light having a specific wavelength, a sharp cut filter, band pass filter, diffraction grating or the like is preferably used as necessary.

Further, the hologram recording material allowing the aforementioned hologram recording method preferably comprises at least:

1) A sensitizing dye made of a metal complex dye which absorbs light upon hologram exposure to generate excited state; and
2) An interference band-recording component containing a dye precursor which can form a coloring material that has absorption at longer wavelength than in the original state and no absorption at hologram reproducing light wavelength, which interference band-recording component can undergo electron movement or energy movement from excited state of sensitizing dye or coloring material to cause color development leading to refractive index modulation by which an interference band is recorded.

Preferred examples of the sensitizing dye and the interference band-recording component include those exemplified with reference to 2) color development reaction.

The light beam emitted at the second step preferably has a wavelength range at which the sensitizing dye exhibits a molar absorptivity of 1,000 or less, more preferably 500 or less.

Further, the light beam emitted at the second step preferably has a wavelength range at which the coloring material exhibits a molar absorptivity of 5,000 or more, more preferably 10,000 or more.

The concept of "latent image color development -coloring material self-sensitized amplification color development reaction process" will be described hereinafter.

For example, the hologram recording material is irradiated with YAG·SHG laser beam having a wavelength of 532 nm so that the laser beam is absorbed by the sensitizing dye to generate excited state. Energy or electron is then moved from the excited state of sensitizing dye to the interference band-recording component to cause the dye precursor contained in the interference band-recording component to change to a coloring material, whereby a latent image is formed by color development (first step). Subsequently, the hologram recording material is irradiated with light beam having a wavelength of from 400 nm to 450 nm so that the light beam is absorbed by the coloring material which is then self-sensitized to cause the amplification thereof (second step). At the area which has become a dark interference area at the first step, there is produced little latent image. Therefore, little self-sensitized color development reaction occurs at the second step as well. As a result, a great refractive index modulation can be performed between the bright interference area and the dark interference area. The refractive index modulation can be recorded as interference band. For example, when the hologram recording material having data, image, etc. recorded thereon is again irradiated with a laser beam having a wavelength of 532 nm, the data, image, etc. can be reproduced.

Specific preferred examples of the latent image color development-coloring material self-sensitized amplification color development reaction include those exemplified in Japanese Patent Application No. 2003-300059.

4) Recording of interference band by latent image color development-coloring material sensitized polymerization reaction

This hologram recording method preferably comprises at least a first step of forming a coloring material having no absorption at hologram reproducing light wavelength as a latent image by hologram exposure and a second step of irradiating the coloring material latent image with light beam having a wavelength different from hologram exposure wavelength to cause polymerization, whereby an interference band is recorded as refractive index modulation, which steps being effected in a dry process. This hologram recording method is excellent in high speed writing properties, storage properties, etc.

It is also preferred that the polymerization be effected while causing self-sensitized amplification of coloring material at the second step.

Further, the hologram recording material allowing the aforementioned hologram recording method comprises at least:

1) A sensitizing dye made of a metal complex dye which absorbs light upon hologram exposure to generate excited state at the first step;
2) A dye precursor which can form a coloring material that has absorption at longer wavelength than in the original state at which wavelength the sensitizing dye exhibits a molar absorptivity of 5,000 or less and no absorption at hologram reproducing light wavelength when electron or energy moves from excited state of sensitizing dye at the first step or from excited state of coloring material at the second step;
3) A polymerization initiator which can initiate the polymerization of a polymerizable compound when electron or energy moves from excited state of sensitizing dye at the first step and from excited state of coloring material at the second step;
4) A polymerizable compound; and
5) A binder.

Preferred examples of the sensitizing dye and the interference band-recording component (dye precursor) include those exemplified with reference to 2) color development reaction.

Preferred examples of the polymerization initiator, the polymerizable compound and the binder include those exemplified with reference to 1) polymerization reaction.

The light beam emitted at the second step preferably has a wavelength range at which the sensitizing dye exhibits a molar absorptivity of 1,000 or less, more preferably 500 or less.

Further, the light beam emitted at the second step preferably has a wavelength range at which the coloring material exhibits a molar absorptivity of 5,000 or more, more preferably 10,000 or more.

In the hologram recording method of the invention and the hologram recording material allowing the hologram recording method, it is preferred from the standpoint of storage, properties and non-destructive reproducibility that the sensitizing dye be decomposed and fixed at the first, the second step or the subsequent fixing step involving either or both of irradiation with light and application of heat. It is more preferred that the sensitizing dye be decomposed and fixed at the first step, the second step or the subsequent fixing step involving either or both of irradiation with light and application of heat and the coloring material be decomposed and fixed at the second step or the subsequent fixing step involving either or both of irradiation with light and application of heat.

The concept of "latent image color development- coloring material sensitized polymerization reaction process" will be described hereinafter.

For example, the hologram recording material is irradiated with YAG·SHG laser beam having a wavelength of 532 nm so that the laser beam is absorbed by the sensitizing dye to generate excited state. Energy or electron is then moved from the excited state of sensitizing dye to the interference band-recording component to cause the dye precursor contained in the interference band-recording component to change to a coloring material, whereby a latent image is formed by color development (first step). Subsequently, the hologram recording material is irradiated with light beam having a wavelength of from 400 nm to 450 nm so that the light beam is absorbed by the coloring material. Thus, electron or energy is moved to the polymerization initiator to activate the polymerization initiator to initiate polymerization. For example, when the polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference band. So far as the sensitizing dye and remaining discolorable dye can be decomposed and discolored at the first and second steps or the subsequent fixing step, a hologram recording material excellent in non-destructive reproduction and storage properties can be provided.

For example, when the hologram recording material having data, image, etc. recorded thereon is again irradiated with a laser beam having a wavelength of 532 nm, the data, image, etc. can be reproduced.

Specific preferred examples of the latent image- coloring material sensitized polymerization reaction include those exemplified in Japanese Patent Application No. 2003-300057.

5) Recording of interference band by the change of orientation of compound intrinsic birefringence

This hologram recording method preferably involves the change of orientation of a compound having an intrinsic birefringence upon hologram exposure. The compound is then chemically reacted so that it is fixed. In this manner, an interference band can be recorded as refractive index modulation in a non-rewritable process. As the compound having an intrinsic birefringence there is preferably used a liquid crystal-based compound, more preferably a low molecular liquid crystal-based compound, even more preferably a low molecular liquid crystal- based compound having a polymerizable group. Specific preferred examples of these compounds include those exemplified in Japanese Patent Application No. 2003- 327594.

6) Dye discoloration reaction

In this hologram recording method, at least one discolorable dye is used and the discolorable dye is discolored during hologram exposure to cause refractive index modulation by which an interference band is formed.

Preferred examples of the hologram recording method include:

(A) A hologram recording method wherein the discolorable dye is a sensitizing dye having absorption in the hologram exposure wavelength and absorbs light during hologram exposure to discolor itself, causing refractive index modulation by which an interference band is formed; and

(B) A hologram recording method wherein there are provided at least a sensitizing dye having absorption at hologram exposure wavelength and a discolorable dye having a molar absorptivity of 1,000 or less, preferably 100 or less at hologram reproducing light wavelength and the sensitizing dye absorbs light during hologram exposure to generate excitation energy by which electron or energy moves to discolor the discolorable dye, causing refractive index modulation by which an interference band is formed. The hologram recording method (B) is preferred.

It is more preferred that there is provided a discoloring agent precursor other than the discolorable dye and the sensitizing dye and when subjected to hologram exposure, the sensitizing dye or the discolorable dye generates excited state in which it then undergoes energy movement or electron movement with the discoloring agent precursor to cause the discoloring agent precursor to generate a discoloring agent which then discolors the discolorable dye, causing refractive index modulation by which an interference band is formed. The discoloring agent is preferably any of radical, acid, base, nucleophilic agent, electrophilic agent and singlet oxygen. Accordingly, the discoloring agent precursor is preferably any of radical generator, acid generator, base generator, nucleophilic agent generator, electrophilic agent generator and triplet oxygen. The discoloring agent precursor is preferably any of radical generator, acid generator and base generator.

The discolorable dye for making the refractive index different from the bright interference area to the dark interference area in the "dye discoloration reaction process" will be further described hereinafter.

In order to allow the discolorable dye to act also as a sensitizing dye in the aforementioned process (A), the previously exemplified examples of sensitizing dye are preferably used as discolorable dye. $\lambda$max of the sensitizing dye/discolorable dye is preferably in between the hologram recording light wavelength and wavelength 100 nm shorter than the hologram recording light wavelength.

On the other hand, in the aforementioned process (B), a discolorable dye is used separately of the sensitizing dye. The discolorable dye to be used herein preferably exhibits a molar absorptivity of 1,000 or less, more preferably 100 or less, most preferably 0 at hologram recording light wavelength. $\lambda$max of the discolorable dye is preferably in between the hologram recording light wavelength and wavelength 200 nm shorter than the hologram recording light wavelength.

In the process (B), the discolorable dye is preferably any of cyanine dye, squarilium cyanine dye, styryl dye, pyrilium dye, melocyanine dye, arylidene dye, oxonol dye, coumarine dye, pyrane dye, xanthene dye, thioxanthene dye, phenothiazine dye, phenoxazine dye, phenazine dye, phthalocyanine dye, azaporphiline dye, porphiline dye, fused ring aromatic dye, perylene dye, azomethine dye, azo dye, anthraquinone dye and metal complex dye, more preferably any of cyanine dye, styryl dye, melocyanine dye, arylidene dye, oxonol dye, coumarine dye, xanthene dye, azomethine dye, azo dye and metal complex dye.

In particular, when the discoloring agent is an acid, the discolorable dye is preferably a dissociation product

of dissociative arylidene dye, dissociative oxonol dye, dissociative xanthene dye or dissociative azo dye, more preferably a dissociation product of dissociative arylidene dye, dissociative oxonol dye or dissociative azo dye. The term "dissociative dye" as used herein generically indicates a dye having an active hydrogen having pKa of from about 2 to 14 such as -OH group, -SH group, -COOH group, $-NHSO_2R$ group and $-CONHSO_2R$ group which undergoes deprotonation to have absorption in longer wavelength or with higher ε. Accordingly, such a dissociative dye can be previously treated with a base to form a dissociated dye from which a dye having absorption in longer wavelength or with higher ε can be prepared, making it possible to render the dye non-dissociative during photo-acid generation so that it is discolored (have absorption in lower wavelength or with lower ε).

In particular, in the case where the discoloring agent is a base, when a product of color development of an acid-colorable dye such as triphenylmethane dye, xanthene dye and fluorane dye with an acid is used as a discolorable dye, it can be converted to unprotonated product and thus discolored (have absorption in lower wavelength or with lower ε) during photo-base generation.

Specific examples of the discolorable dye of the invention will be given below, but the invention is not limited thereto.

G-1

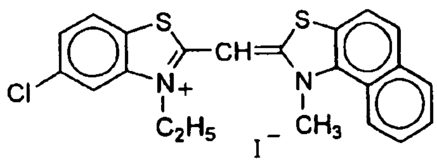

G-2

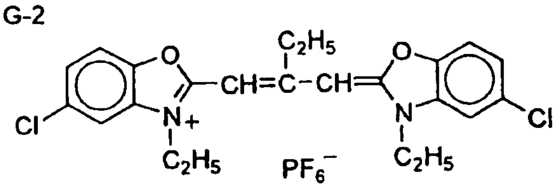

G-3

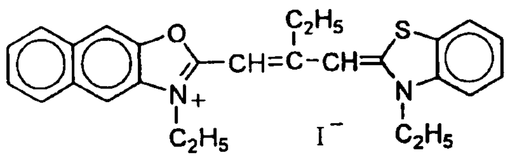

G-4

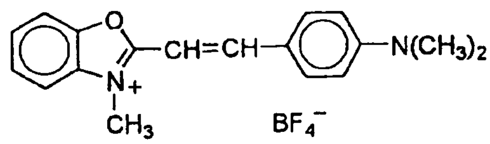

G-5

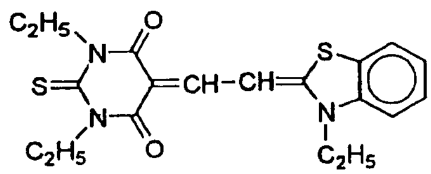

G-6

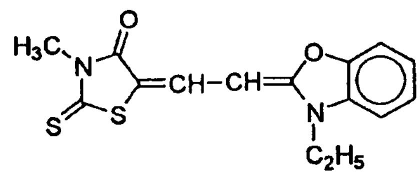

G-7

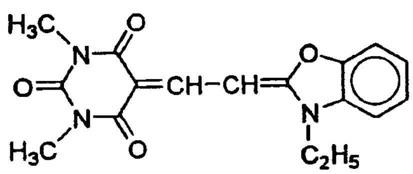

G-8

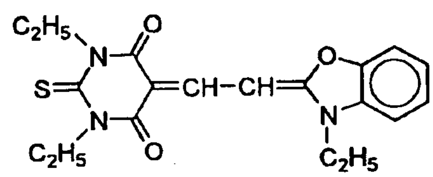

G-9

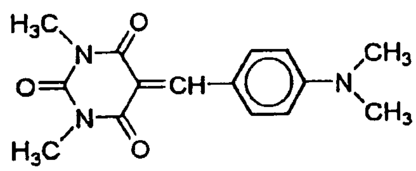

G-10

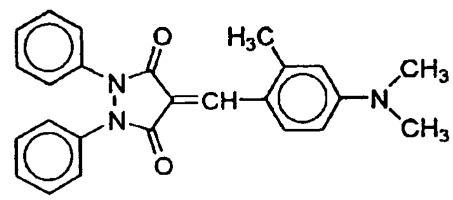

G-11

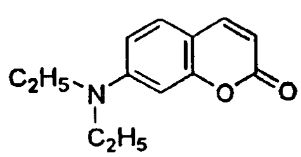

G-12

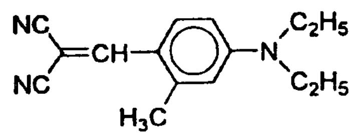

<Dissociation product of dissociative dye, mainly acid-discolorable dye>

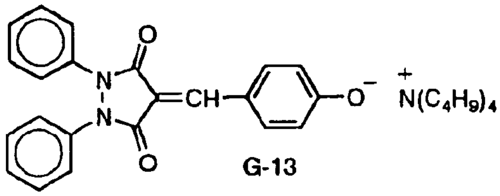

G-13

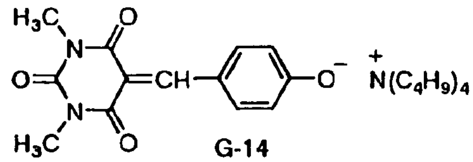

G-14

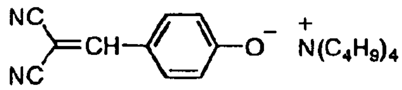

G-15

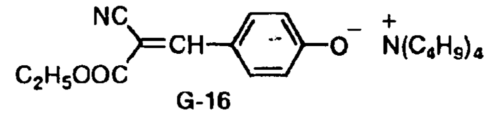

G-16

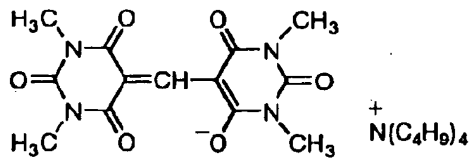

G-17

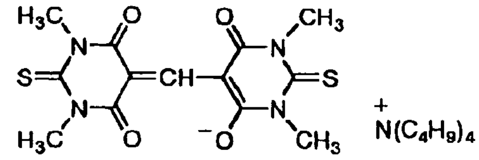

G-18

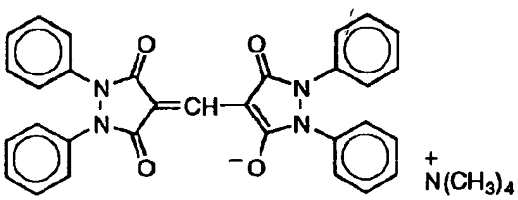

G-19

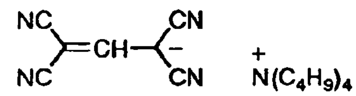

G-20

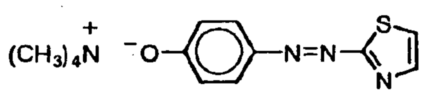

G-21

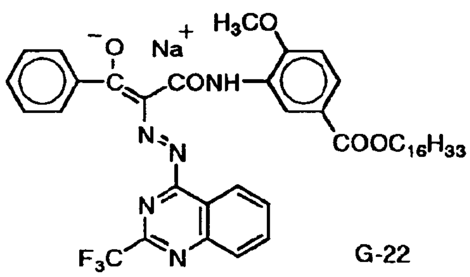

G-22

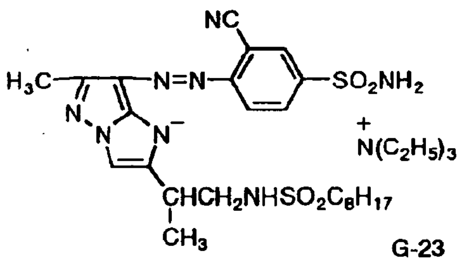

G-23

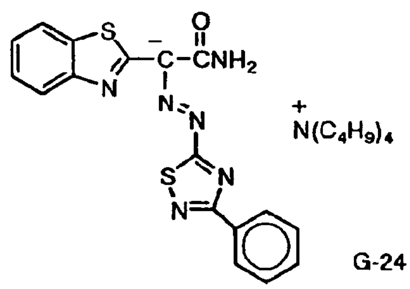

G-24

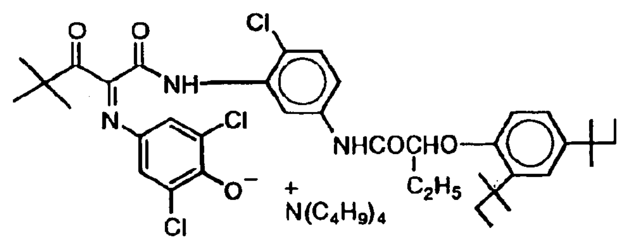

G-25

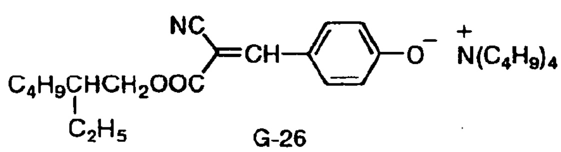

G-26

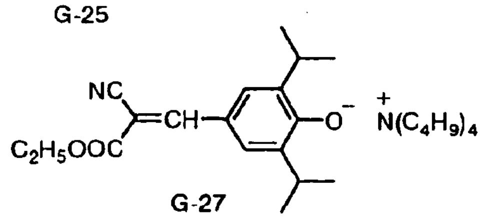

G-27

<Color development product of acid-colorable dye, mainly base-discolorable dye>

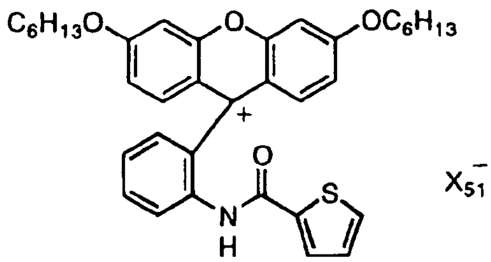

G-28

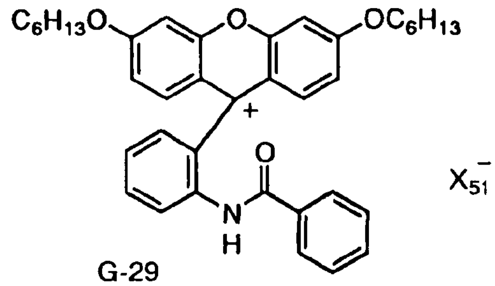

G-29

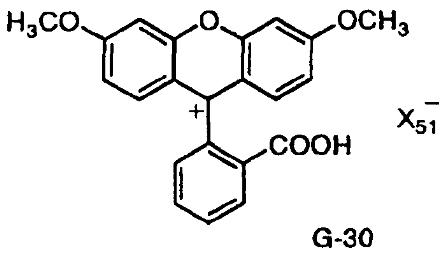

G-30

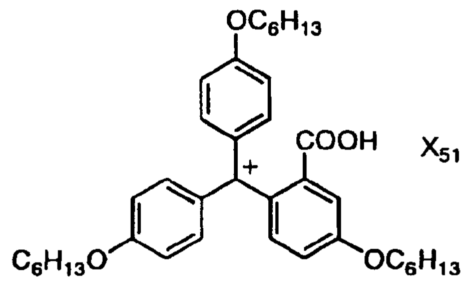

G-31

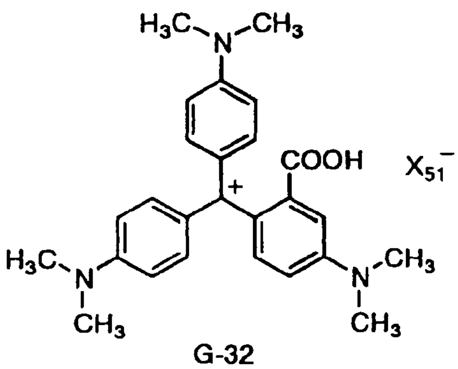

G-32

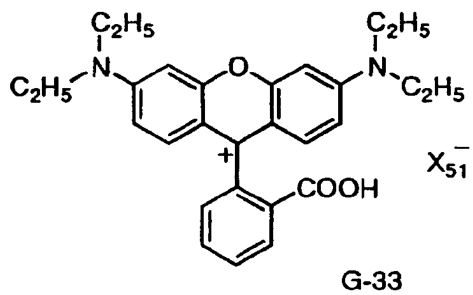

G-33

Preferred examples of the discoloring agent precursor which is an acid generator include those exemplified above with reference to cationic polymerization initiator. Preferred examples of the discoloring agent precursor which is a radical generator include those exemplified above with reference to radical polymerization initiator. Preferred examples of the discoloring agent precursor which is a base generator include those exemplified above with reference to anionic polymerization initiator.

Specific preferred examples of the dye discoloration reaction include those exemplified in Japanese Patent Application No. 2004-88790.

7) Remaining discolorable dye latent image-latent image sensitized polymerization reaction

This hologram recording method preferably comprises a first step at which the sensitizing dye having absorption at hologram exposure wavelength absorbs light during hologram exposure to generate excited state with the energy of which it then discolors the discolorable dye having a molar absorptivity of 1,000 or less, preferably 100 or less, most preferably 0 at hologram reproducing light wavelength, whereby the discolorable dye left undiscolored forms a latent image and a second step at which the latent image of discolorable dye left undiscolored is irradiated with light having a wavelength different from that used for hologram exposure to cause polymerization by which an interference band is recorded as refractive index modulation. This hologram recording method is excellent in high speed recording properties, adaptability to multiplexed recording, storage properties after recording, etc.

This hologram recording method more preferably comprises a first step at which the sensitizing dye having absorption at hologram exposure wavelength absorbs light during hologram exposure to generate excited state in

which it then undergoes energy movement or electron movement with the discoloring agent precursor as defined in Clause (6) to cause the discoloring agent precursor to generate a discoloring agent which then discolors the discolorable dye whereby the discolorable dye left undiscolored forms a latent image and a second step at which the latent image of discolorable dye left undiscolored is irradiated with light having a wavelength different from that used for hologram exposure to cause energy movement or electron movement by which a polymerization initiator is activated to cause polymerization by which an interference band is recorded as refractive index modulation.

Further, the compound group allowing the aforementioned hologram recording method preferably comprises:

1) A sensitizing dye made of a metal complex dye which absorbs light upon hologram exposure to generate excited state at the first step;
2) A discolorable dye having a molar absorptivity of 1,000 or less capable of performing direct electron movement or energy movement to the discoloring agent precursor from excited state of sensitizing dye to undergo discoloration at the first step;
3) A discoloring agent precursor which can (optionally) undergo electron movement or energy movement from excited state of sensitizing dye to generate a discoloring agent at the first step;
4) A polymerization initiator (optionally acting as a discoloring agent precursor 3) as well) which can undergo electron movement or energy movement from excited state of remaining discolorable dye to initiate the polymerization of the polymerizable compound at the second step;
5) A polymerizable compound; and
6) A binder.

Specific preferred examples of the sensitizing dye include those exemplified with reference to 2) color development reaction.

Preferred examples of the polymerization initiator, the polymerizable compound and the binder include those exemplified with reference to 1) polymerization reaction.

The light beam emitted at the second step preferably has a wavelength range at which the sensitizing dye exhibits a molar absorptivity of 1,000 or less, more preferably 500 or less.

Further, the light beam emitted at the second step preferably has a wavelength range at which the coloring material exhibits a molar absorptivity of 5,000 or more, more preferably 10,000 or more.

In the hologram recording method of the invention and the hologram recording material allowing the hologram recording method, it is preferred from the standpoint of storage properties and non-destructive reproducibility that the sensitizing dye be decomposed and fixed at the first, the second step or the subsequent fixing step involving either or both of irradiation with light and application of heat. It is more preferred that the sensitizing dye be decomposed and fixed at the first step, the second step or the subsequent fixing step involving either or both of irradiation with light and application of heat and the remaining discolorable dye be decomposed and fixed at the second step or the subsequent fixing step involving either or both of irradiation with light and application of heat.

Preferred examples of the sensitizing dye, the discolorable dye, the polymerizable compound and the binder include those exemplified above.

In the "remaining discolorable dye latent image- latent image sensitized polymerization process" of the invention, it is also preferred that the discoloring agent precursor and the polymerization initiator partly or wholly act as each other.

In the case where a discolorable dye is added in addition to sensitizing dye, when the discoloring agent precursor and the polymerization initiator are different from each other (e.g., when the discoloring agent precursor is an acid generator or base general formula and the polymerization initiator is a radical polymerization initiator or when the discoloring agent precursor is a radical generator or nucleophilic agent generator and the polymerization initiator is an acid generator or base generator), it is preferred that the sensitizing dye can perform electron movement sensitization only on the discoloring agent precursor and the polymerization initiator can perform electron movement sensitization only by the discolorable dye.

The concept of "remaining discolorable dye latent image-latent image sensitized polymerization reaction process" will be described hereinafter.

For example, the hologram recording material is irradiated with YAG·SHG laser beam having a wavelength of 532 nm so that the laser beam is absorbed by the sensitizing dye to generate excited state. Energy or electron is then moved from the excited state of sensitizing dye to the discoloring agent precursor to generate a discoloring agent by which the discolorable dye is then discolored. As a result, a latent image can be formed by the remaining discolorable dye (first step).

Subsequently, the hologram recording material is irradiated with light beam having a wavelength of from 400 nm to 450 nm so that the light beam is absorbed by the remaining discolorable dye. Then, electron or energy is moved to the polymerization initiator to activate the polymerization initiator to initiate polymerization. For example, when the

polymerizable compound has a smaller refractive index than the binder, the polymerizable compound gathers at the polymerization area, causing the drop of refractive index (second step). At the area which has become a bright interference area at the first step, there is less remaining discolorable dye forming a latent image. Therefore, little polymerization occurs in the bright interference area at the second step. Thus, the proportion of binder is higher in the bright interference area. As a result, a great refractive index modulation can be performed between the bright interference area and the dark interference area. The refractive index modulation can be recorded as interference band. So far as the sensitizing dye and remaining discolorable dye can be decomposed and discolored at the first and second steps or the subsequent fixing step, a hologram recording material excellent in non-destructive reproduction and storage properties can be provided.

For example, when the hologram recording material having data, image, etc. recorded thereon is again irradiated with a laser beam having a wavelength of 532 nm, the data, image, etc. can be reproduced. Alternatively, the hologram recording material of the invention can act as a desired optical material.

Specific preferred examples of the remaining discolorable dye latent image-latent image sensitized polymerization reaction include those exemplified in Japanese Patent Application No. 2004-88790.

The hologram recording material of the invention may further comprise additives such as electron-donating compound, electron-accepting compound, chain transfer agent, crosslinking agent, heat stabilizer, plasticizer and solvent incorporated therein besides the aforementioned sensitizing dye, interference band-recording component, polymerization initiator, polymerizable compound, binder, discolorable dye, discoloring agent precursor, etc. as necessary.

The electron-donating compound is capable of reducing the radical cation in the sensitizing dye or coloring material. The electron-accepting compound is capable of oxidizing the radical anion in the sensitizing dye or coloring material. Thus, both the electron-donating compound and the electron-accepting compound are capable of reproducing the sensitizing dye. Specific preferred examples of these compounds include those exemplified in Japanese Patent Application No. 2003-298936.

In particular, the electron-donating compound is useful for the enhancement of sensitivity because it can rapidly reproduce the sensitizing dye or coloring material radical cation produced by the movement of electron to the dye precursor group. As the electron-donating compound there is preferably used one having a more negative oxidation potential than sensitizing dye and coloring material. Specific preferred examples of the electron-donating compound will be given below, but the invention is not limited thereto.

Examples of electron-donating compound for reproduction of sensitizing dye

A-1

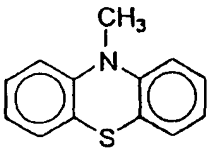

A-2

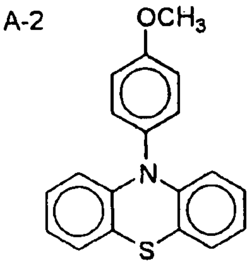

A-3

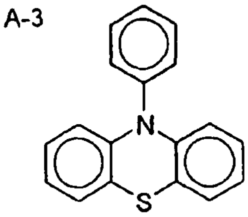

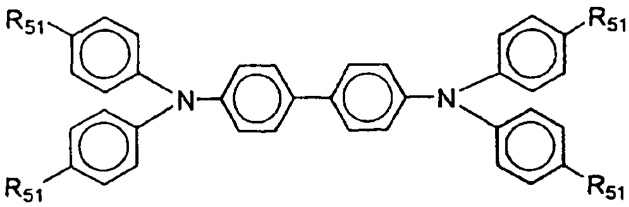

| | $R_{51}$ |
|---|---|
| A-4 | H |
| A-5 | $-OCH_3$ |

A-6

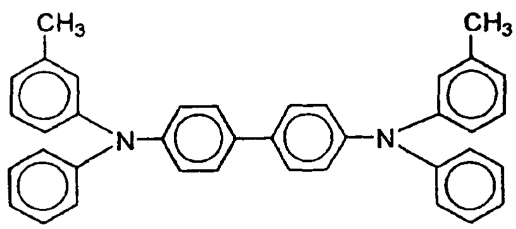

A-7

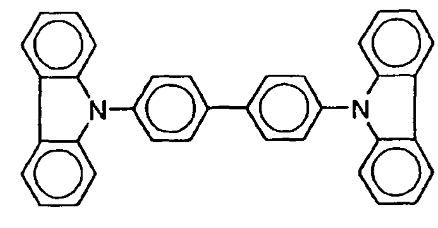

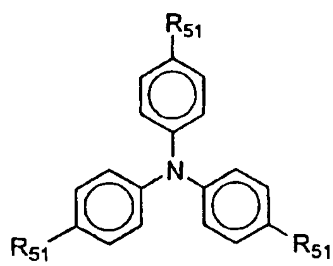

| | $R_{51}$ |
|---|---|
| A-8 | H |
| A-9 | $-CH_3$ |
| A-10 | $-OCH_3$ |

A-11

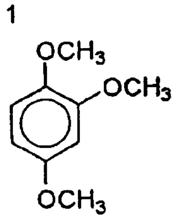

A-12

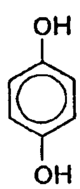

A-13

$(C_4H_9)_4\overset{+}{N}\ I^-$

A-14

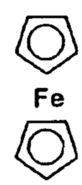

Particularly preferred examples of the electron- donating compound include phenothiazine-based compounds (e.g., 10-methylphenothiazine, 10-(4'-methoxyphenyl) phenothiazine), triphenylamine-based compounds (e.g., triphenylamine, tri(4'-methoxyphenyl)amine), and TPD- based compounds (e.g., TPD). Most desirable among these electron-donating compounds are phenothiazine-based compounds.

Specific preferred examples of chain transfer agent, crosslinking agent, heat stabilizer, plasticizer, solvent, etc. include those exemplified in Japanese Patent Application No. 2003-300057.

In the case where the hologram recording material of the invention is used for holographic light memory, it is preferred from the standpoint of enhancement of S/N ratio during the reproduction of signal that the hologram recording material undergo no shrinkage after hologram recording.

To this end, it is preferred that the hologram recording material of the invention comprise an inflating agent disclosed in JP-A-2000-86914 incorporated therein or a shrinkage-resistant binder disclosed in JP-A-2000-250382, JP-A-2000-172154 and JP- A-11-344917 incorporated therein.

Further, it is preferred that the interference band gap be adjusted using a diffusion element disclosed in JP-A-3-46687, JP-A-5-204288, JP-T-9-506441, etc.

When a known ordinary photopolymer as disclosed in JP-A-6-43634, JP-A-2-3082, JP-A-3-50588, JP-A-5-107999, JP-A-8-16078, JP-T-2001-523842 and JP-T-11-512847 is subjected to multiplexed recording, the latter half of multiplexed recording is conducted on the area where polymerization has proceeded so much. Therefore, the latter half of multiplexed recording requires more exposure time to record the same signal than the former half of multiplexed recording (lower sensitivity). This has been a serious problem in system design. In other, it has been disadvantageous in that the range within which the refractive index modulation shows linear rise with respect to exposure is very narrow.

On the contrary, 2) color development reaction, 3) latent image color development-coloring material self-sensitized amplification color development reaction and 6) dye discoloration reaction process recording methods of the invention involve no polymerization during the recording of interference band. Even 4) latent image color development-coloring material sensitized polymerization reaction and 7) remaining discolorable dye latent image-latent image sensitized polymerization reaction process recording methods of the invention involve little polymerization reaction during hologram exposure (first step) and entire exposure causing block polymerization by which refractive index modulation is conducted at the second step. Accordingly, much multiplexed recording can be conducted in any of the recording methods 2) to 4). Further, any multiplexed recording can be conducted at a constant exposure, i.e., with a linear rise of refractive index modulation relative to exposure. Therefore, a broad dynamic range can be obtained. Thus, 2) to 4) and 6) and 7) process recording methods of the invention are very advantageous from the standpoint of the aforementioned adaptability to multiplexed recording.

This is advantageous from the standpoint of enhancement of capacity, simplification of recording system, enhancement of S/N ratio, etc.

Further, the recording methods of 2) to 4) processes are capable of recording at a very high sensitivity as compared with known processes.

As mentioned above, the hologram recording material of the invention gives drastic solution to the aforementioned problems. In particular, the hologram recording material of the invention allows quite a new recording method which attains high sensitivity, good storage properties, dry processing properties and multiplexed recording properties. The hologram recording material is particularly suited for optical recording medium (holographic optical memory).

The hologram recording material of the invention can be used as three-dimensional display hologram, holographic optical element (HOE, such as headup display (HUD) for automobile, pickup lens for optical disc, head mount display, color filter for liquid crystal, reflector for reflective liquid crystal, lens, diffraction grating, interference filter, connector for optical fiber, light polarizer for facsimile, window glass for building), cover paper for book, magazine, and display for POP, etc. The hologram recording material of the invention is preferably used for gift and credit card, paper money and packaging for the purpose of security against forgery.

[Example]

Specific examples of the invention will be described in connection with the results of experiments, but the invention is not limited thereto.

[Example 1]

[Hologram recording method by polymerization process]

The sensitizing dye DEAW described in JP-A-6- 43634 exhibits a molar absorptivity of 5,550 (methylene chloride) at 532 nm. The metal complex dyes S-1, S-26 and S-49 of the invention exhibits a molar absorptivity of 13 (methylene chloride), 1,120 (acetone) and 660 (acetone) at 532 nm, respectively.

As mentioned in Example 1 of JP-A-6-43634, the radical polymerization initiator I-2, the chain transfer agent MBO, POEA as a monomer and cellulose acetate butyrate CAB531-1 as a binder were prepared in an amount of 1.20%, 1.80%, 46.5% and 50.5%, respectively. The molarity of the sensitizing dye was calculated such that the transmittance of the hologram recording material having a thickness of 200 μm at a hologram recording wavelength of 532 nm is 80%. The molarity thus calculated was then multiplied by the molecular weight of the sensitizing dye. DEAW, S-1, S-26 and S-49 were then prepared in an amount of 0.037%, 7.4%, 0.39% and 0.71% of the solid content thus determined, respectively. These materials were then dissolved in a three-fold weight of methylene chloride (optionally with 2-butanone, acetone and acetonitrile) to prepare Comparative Sample 1 and Inventive Samples 101, 102 and 103, respectively.

The comparative hologram recording material composition 1 and the inventive hologram recording material compositions 101 to 103 were each spread (optionally in a multi-layer form) over a glass substrate to a thickness of about 200 μm using a blade to form a photosensitive layer which was then heated and dried at 40°C for 3 minutes to remove the solvent. The photosensitive layer was then covered by TAC layer to prepare inventive hologram recording material 1 and inventive hologram recording materials 101 to 103.

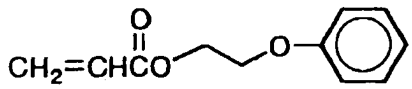

POEA

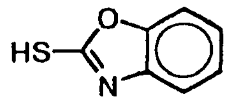

MBO

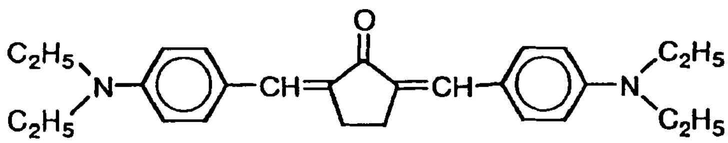

DEAW

The hologram recording materials were each then exposed to YAG laser second harmonic (532 nm; output: 2W) as a light source in a two-flux optical system for transmission hologram recording shown in Fig. 1 to perform recording. In Fig.1, 10 denotes YAG laser, 12 denotes Laser beam, 14 denotes Mirror, 20 denotes Beam splitter, 22 denotes Beam segment, 24 denotes Mirror, 26 denotes Spatial filter, 40 denotes Beam expander, 30 denotes Hologram recording material 28 denotes Sample, 32 denotes He-Ne laser beam, 34 denotes He-Ne laser, 36 denotes Detector and 38 denotes Rotary stage. The angle of the object light with respect to the reference light was 30 degrees. The light beam had a diameter of 0.6 cm and an intensity of 12 $mW/cm^2$. During exposure, the holographic exposure time was varied from 0.1 to 100 seconds (radiation energy ranging from 1.2 to 1,200 $mJ/cm^2$). During hologram exposure, He-Ne laser beam having a wavelength of 632 nm was passed through the center of exposed area at the Bragg angle. The ratio of diffracted light to transmitted light (relative diffraction efficiency) was then measured at real time.

The exposure energy at which the inventive hologram recording materials 101 to 103 show half the maximum diffraction efficiency were all as small as 0.2, 0.5 and 0.3, respectively, relative to that of the comparative hologram recording material 1 as 1. Thus, the inventive hologram recording materials 101 to 103 exhibited a high sensitivity. It is thus made obvious that the metal complex dye of the invention exhibits a higher sensitivity than known sensitizing dyes in the polymerization process (photopolymer process).

Even when the sensitizing dye to be used in Samples 101 to 103 were changed to S-2, S-6, S-20, S-31, S-34, S-37, S-38, S-54, S-55, S-56, S-63, S-68, S-71, S-72, S-85, S-89, S-90 or S-93, similar effects were obtained.

[Example 2]

[Hologram recording method by color development process]

The acid generator I-5 (50% based on the weight of binder), the dye precursor L-2 (10% based on the weight of binder), and the binder PMMA-EA (poly(methyl methacrylate-5% ethyl acrylate) copolymer; Mw: 101,000) were prepared. As sensitizing dyes there were prepared DEAW, S-1, S-26 and S-49 in an amount of 0.037%, 7.4%, 0.39% and 0.71% of the solid content determined above, respectively. These materials were then dissolved in a two- to four-fold weight of methylene chloride (optionally with acetone or acetonitrile) under a red lamp to prepare a comparative hologram recording material composition 2 and inventive hologram recording material compositions 201 to 203, respectively.

The comparative hologram recording material composition 2 and the inventive hologram recording material compositions 201 to 203 were each spread (optionally in a multi-layer form) over a glass substrate under a red lamp to a thickness of about 200 μm using a blade to form a photosensitive layer which was then heated and dried at 40°C for 3 minutes to remove the solvent. The photosensitive layer was then covered by TAC layer to prepare inventive hologram recording material 2 and inventive hologram recording materials 201 to 203.

The hologram recording materials were each then exposed to YAG laser second harmonic (532 nm; output: 2W) as a light source in a two-flux optical system for transmission hologram recording shown in Fig. 1 to perform

recording. The angle of the object light with respect to the reference light was 30 degrees. The light beam had a diameter of 0.6 cm and an intensity of 12 $mW/cm^2$. During exposure, the holographic exposure time was varied from 0.1 to 200 seconds (radiation energy ranging from 1.2 to 2,400 $mJ/cm^2$). During hologram exposure, He-Ne laser beam having a wavelength of 632 nm was passed through the center of exposed area at the Bragg angle. The ratio of diffracted light to transmitted light (relative diffraction efficiency) was then measured at real time.

The exposure energy at which the inventive hologram recording materials 201 to 203 show half the maximum diffraction efficiency were all as small as 0.07, 0.06 and 0.02, respectively, relative to that of the comparative hologram recording material 2 as 1. Thus, the inventive hologram recording materials 201 to 203 exhibited a high sensitivity. It is thus made obvious that the metal complex dye of the invention exhibits a higher sensitivity than known sensitizing dyes in the color development process. The inventive hologram recording materials 201 to 203 exhibited a diffraction efficiency as high as 85%, 82% and 86%, respectively, while the comparative hologram recording material 2 exhibited a diffraction efficiency as low as 30%.

The diffraction efficiency rose substantially linearly with exposure.

As can be seen in the aforementioned results, the combination of the metal complex dye as sensitizing dye with the novel "color development reaction process" hologram recording material and method of the invention allows hologram recording having a high sensitivity and adaptability to multiplexed recording.

Multiplexed hologram recording was actually made on the same area of a hologram recording material of the invention 10 times at a dose corresponding to one tenth of the exposure giving half the aforementioned maximum diffraction efficiency and a reference light angle varying by 2 degrees every recording job. Thereafter, the hologram recording material was irradiated with a reproducing light beam at an angle varying by 2 degrees. As a result, it was confirmed that these object light beams can be reproduced. It can be thus made obvious that the hologram recording material of the invention can be subjected to multiplexed recording at the same exposure and thus is adapted for multiplexed recording.

Even when the sensitizing dye to be used in Examples 201 to 203 were changed to S-2, S-6, S-20, S-31, S-34, S-37, S-38, S-54, S-55, S-56, S-63, S-68, S-71, S-72, S-85, S-89, S-90 or S-93, similar effects were obtained.

Further, even when the dye precursor (cationic and/or radical polymerization initiator) to be used in Samples 201 to 203 was changed to I-3, I-4, I-6, I-7, I-8, I-9 or I-10, similar effects were obtained.

Further, even when the binder to be used in Samples 201 to 203 was changed to polymethyl methacrylates (Mw: 996,000, 350,000, 120,000), poly (methyl methacrylate-butyl methacrylate) copolymer (Mw: 75,000), polyvinyl acetate (Mw: 83,000), etc., similar effects were obtained.

[Example 3]

[Hologram recording method by discoloration process (sensitizing dye + discolorable dye)]

The acid generator I-5 (50% based on the weight of binder), the discolorable dye G-16 (8% based on the weight of binder), and the binder PMMA-EA (poly(methyl methacrylate-5% ethyl acrylate) copolymer; Mw: 101,000) were prepared. As sensitizing dyes there were prepared DEAW, S-1, S-26 and S-49 in an amount of 0.037%, 7.4%, 0.39% and 0.71% of the solid content determined above, respectively. These materials were then dissolved in a two- to four-fold weight of methylene chloride (optionally with acetone or acetonitrile) under a red lamp to prepare a comparative hologram recording material composition 3 and inventive hologram recording material compositions 301 to 303, respectively.

The comparative hologram recording material composition 3 and the inventive hologram recording material compositions 301 to 303 were each spread (optionally in a multi-layer form) over a glass substrate under a red lamp to a thickness of about 200 μm using a blade to form a photosensitive layer which was then heated and dried at 40°C for 3 minutes to remove the solvent. The photosensitive layer was then covered by TAC layer to prepare inventive hologram recording material 3 and inventive hologram recording materials 301 to 303.

The hologram recording materials were each then exposed to YAG laser second harmonic (532 nm; output: 2W) as a light source in a two-flux optical system for transmission hologram recording shown in Fig. 1 to perform recording. The angle of the object light with respect to the reference light was 30 degrees. The light beam had a diameter of 0.6 cm and an intensity of 12 $mW/cm^2$. During exposure, the holographic exposure time was varied from 0.1 to 200 seconds (radiation energy ranging from 1.2 to 2,400 $mJ/cm^2$). During hologram exposure, He-Ne laser beam having a wavelength of 632 nm was passed through the center of exposed area at the Bragg angle. The ratio of diffracted light to transmitted light (relative diffraction efficiency) was then measured at real time

The exposure energy at which the inventive hologram recording materials 301 to 303 show half the maximum diffraction efficiency were all as small as 0.08, 0.07 and 0.03, respectively, relative to that of the comparative hologram recording material 3 as 1. Thus, the inventive hologram recording materials 301 to 303 exhibited a high sensitivity. It is thus made obvious that the metal complex dye of the invention exhibits a higher sensitivity than known sensitizing

dyes in the discoloration process. The inventive hologram recording materials 301 to 303 exhibited a diffraction efficiency as high as 87%, 84% and 87%, respectively, while the comparative hologram recording material 3 exhibited a diffraction efficiency as low as 28%.

The diffraction efficiency rose substantially linearly with exposure.

As can be seen in the aforementioned results, the combination of the metal complex dye as sensitizing dye with the novel "discoloration reaction process" hologram recording material and method of the invention allows hologram recording having a high sensitivity and adaptability to multiplexed recording.

Multiplexed hologram recording was actually made on the same area of a hologram recording material of the invention 10 times at a dose corresponding to one tenth of the exposure giving half the aforementioned maximum diffraction efficiency and a reference light angle varying by 2 degrees every recording job. Thereafter, the hologram recording material was irradiated with a reproducing light beam at an angle varying by 2 degrees. As a result, it was confirmed that these object light beams can be reproduced. It can be thus made obvious that the hologram recording material of the invention can be subjected to multiplexed recording at the same exposure and thus is adapted for multiplexed recording.

Even when the sensitizing dye to be used in Examples 301 to 303 were changed to S-2, S-20, S-31, S-34, S-37, S-38, S-54, S-55, S-56, S-63, S-68, S-71, S-72, S-85, S-89, S-90 or S-93, similar effects were obtained.

Further, even when the acid-discolorable dye to be used in Samples 301 to 303 was changed to G-13, G-14, G-16, G-17, G-19, G-21, G-22, G-24, G-25, G-26 or G-27, similar effects were obtained.

Further, even when the discoloring agent precursor (acid generator) to be used in Samples 301 to 303 was changed to I-3, I-4, I-6, I-7, I-9 or I-10, similar effects were obtained.

Further, even when the binder to be used in Samples 301 to 303 was changed to polymethyl methacrylates (Mw: 996,000, 350,000, 120,000), poly (methyl methacrylate-butyl methacrylate) copolymer (Mw: 75,000), polyvinyl acetate (Mw: 83,000), etc., similar effects were obtained.

In accordance with the invention, a hologram recording material and hologram recording method can be obtained which can be applied to high density optical recording medium, three-dimensional display, holographic optical element, etc. and can attain a high sensitivity, high diffraction efficiency, good storage properties, low shrinkage factor, dry processing properties and multiplexed recording properties at the same time. A sensitizing dye can be also obtained which can be used with a high sensitivity even in a hologram recording material having a thickness as great as 100 μm or more, particularly in a high density optical recording medium, to perform multiplexed recording comprising many recording jobs and obtain a high recording density.

The entire disclosure of each and every foreign patent application from which the benefit of foreign priority has been claimed in the present application is incorporated herein by reference, as if fully set forth.

## Claims

1. A hologram recording material comprising at least one metal complex dye as a sensitizing dye.

2. The hologram recording material as defined in claim 1, wherein the metal complex dye is a metalocene dye represented by general formula (I):

(I)

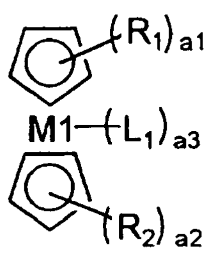

wherein $M_1$ represents a metal atom; $R_1$ and $R_2$ each independently represents a substituent; $L_1$ represents a ligand which can be bonded to $M_1$; a1 and a2 each independently represents an integer of from 0 to 5, and when a1 and a2 each is 2 or more, each of a plurality of $R_1$'s and $R_2$'s may be the same or different and may be connected to each other to form a ring; and a3 represents an integer of from 0 to 6.

**3.** The hologram recording material as defined in claim 2, wherein the metalocene dye is a ferrocene derivative.

**4.** The hologram recording material as defined in claim 1, wherein the metal complex dye is a metal complex dye represented by any of general formulae (II-1) to (II-3):

(II-1)

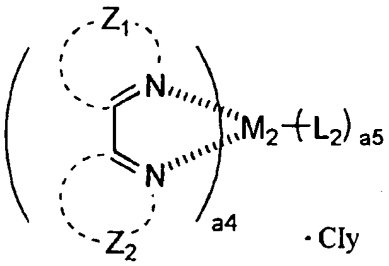

(II-2)

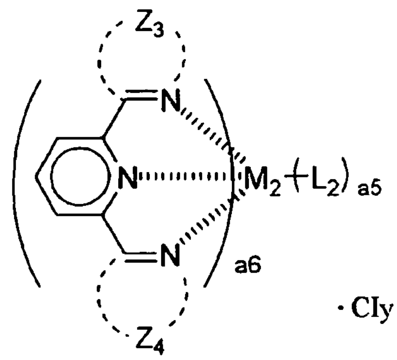

(II-3)

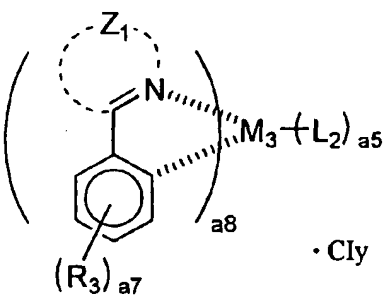

in the formula (II-1), $M_2$ represents a metal atom; $Z_1$ and $Z_2$ each independently represents a non-metal atom group which can form a 5- or 6-membered heterocyclic group; $L_2$ represents a ligand; a4 represents an integer of from 1 to 3; a5 represents an integer of from 0 to 4; CI represents an ion required to neutralize charge; and y represents an integer;

in the formula (II-2), $M_2$, $L_2$, a5, CI and y are as defined above; $Z_3$ and $Z_4$ each independently represents a non-metal atom group which can form a 5- or 6-membered heterocyclic group; a6 represents an integer of 1 or 2;

in the formula (II-3), $Z_1$, $L_2$, a5, CI and y are as defined above; $M_3$ represents a metal atom; $R_3$ represents a substituent; a7 represents an integer of from 0 to 4, and when a7 is 2 or more, the plurality of $R_3$'s may be the same or different and may be connected to each other to form a ring; a8 represents an integer of from 1 to 3.

**5.** The hologram recording material as defined in claim 1, wherein the metal complex dye is an MLCT type metal complex dye.

**6.** The hologram recording material as defined in claim 1, wherein the metal complex dye is a Ru complex dye.

**7.** The hologram recording material as defined in claim 1, wherein the metal complex dye exhibits a molar absorptivity of from 1 to 2,000 at hologram recording wavelength.

**8.** The hologram recording material as defined in claim 1, wherein the metal complex dye has a molar absorptivity at hologram recording wavelength not greater than one fifth of that at $\lambda$max.

**9.** The hologram recording material as defined in claim 1, which has a thickness of 100 µm or more, and comprises the sensitizing dye so as to have a light transmittance of from 10% to 99% at hologram recording wavelength.

**10.** A hologram recording method using a hologram recording material as defined in claim 1 to record an interference band as refractive index modulation, the method comprising performing any of 1) polymerization reaction, 2) color development reaction, 3) latent image color development- coloring material self-sensitized amplification color development reaction, 4) latent image color development- coloring material sensitized polymerization reaction, 5) change of orientation of a compound having an intrinsic birefringence, 6) dye discoloration reaction and 7) remaining discolorable dye latent image-latent image polymerization reaction.

**11.** The hologram recording method as defined in claim 10,
wherein hologram recording involving 3) latent image color development-coloring material self-sensitized amplification color development reaction comprises:

a first step of forming a coloring material having no absorption at hologram reproducing light wavelength as a latent image by hologram exposure and;
a second step of irradiating the coloring material latent image with light having a wavelength different from hologram exposure wavelength at which the sensitizing dye exhibits a molar absorptivity of 5,000 or less, to cause the self-sensitized amplification of the coloring material and record the interference band as the refractive index modulation,

wherein the first and second steps are effected in a dry process.

**12.** A hologram recording material for use in a hologram recording method as defined in claim 10 involving one of 2) color development reaction and 3) latent image color development- coloring material self-sensitized amplification color development reaction, the hologram recording material comprising:

1) a sensitizing dye comprising a metal complex dye which absorbs light upon hologram exposure to generate an excited state; and
2) an interference band-recording component containing a dye precursor which can form a coloring material having an absorption at longer wavelength than that of the dye precursor and no absorption at hologram reproducing light wavelength, wherein the interference band-recording component can undergo electron movement or energy movement from the excited state of the sensitizing dye or an excited state of the coloring material, to cause color development leading to the refractive index modulation by which the interference band is recorded.

**13.** The hologram recording method as defined in claim 10,
wherein hologram recording involving 4) latent image color development-coloring material sensitized polymerization reaction comprises:

a first step of forming a coloring material having no absorption at hologram reproducing light wavelength as a latent image by hologram exposure; and
a second step of irradiating the latent image with light having a wavelength different from hologram exposure wavelength to cause polymerization and record the interference band as the refractive index modulation,

wherein the first and second steps are effected in a dry process.

**14.** A hologram recording material for use in a hologram recording method as defined in claim 13, the hologram recording material comprising:

1) a sensitizing dye comprising a metal complex dye which absorbs light upon hologram exposure to generate an excited state at the first step;
2) a dye precursor which can form a coloring material having (i) an absorption at longer wavelength than that of the dye precursor, (ii) an absorption at which wavelength the sensitizing dye exhibits a molar absorptivity of 5,000 or less and (iii) no absorption at hologram reproducing light wavelength when electron or energy moves from the excited state of the sensitizing dye at the first step or from an excited state of the coloring material at the second step;
3) a polymerization initiator which can initiate a polymerization of a polymerizable compound when electron or energy moves from the excited state of the sensitizing dye at the first step or from the excited state of the coloring material at the second step;
4) the polymerizable compound; and

5) a binder.

**15.** The hologram recording method as defined in claim 10,
wherein hologram recording involving 6) dye discoloration reaction uses a discoloring agent precursor and a discoloring agent, in which, when subjected to hologram exposure, the sensitizing dye or a discolorable dye generates excited state in which it then undergoes energy movement or electron movement with the discoloring agent precursor to cause the discoloring agent precursor to generate a discoloring agent that discolors the discolorable dye, causing the refractive index modulation by which the interference band is formed; and
wherein the discoloring agent precursor is any of radical generator, acid generator, base generator, nucleophilic agent generator, electrophilic agent generator and triplet oxygen.

**16.** The hologram recording method as defined in claim 10,
wherein hologram recording involving 7) remaining discolorable dye latent image-latent image polymerization reaction comprises:

a first step at which the sensitizing dye having an absorption at hologram exposure wavelength absorbs light during hologram exposure to generate excited state in which it undergoes energy movement or electron movement with a discoloring agent precursor to cause the discoloring agent precursor to generate a discoloring agent that discolors a discolorable dye, so as to form a discolorable dye left undiscolored forms as a latent image; and
a second step at which the latent image of the discolorable dye left undiscolored is irradiated with light having a wavelength different from that used for hologram exposure, to activate a polymerization initiator to cause polymerization by which the interference band is recorded as the refractive index modulation.

**17.** A hologram recording material for use in the hologram recording method as defined in claim 16, the hologram recording material comprising:

1) a sensitizing dye comprising a metal complex dye that absorbs light upon hologram exposure to generate the excited state at the first step;
2) a discolorable dye having a molar absorptivity of 1,000 or less capable of undergoing discoloration due to one of (i) direct electron movement or energy movement to the discolorable dye from the excited state of the sensitizing dye at the first step and (ii) electron movement or energy movement to the discoloring agent precursor from the excited state of the sensitizing dye at the first step;
3) a discoloring agent precursor that can undergo the electron movement or the energy movement from the excited state of the sensitizing dye to generate a discoloring agent at the first step;
4) a polymerization initiator which can undergo the electron movement or the energy movement from an excited state of the discolorable dye left undiscolored to initiate the polymerization of a polymerizable compound at the second step, wherein the polymerization initiator can act as the discoloring agent precursor 3);
5) the polymerizable compound; and
6) a binder.

**18.** The hologram recording material as defined in claim 1, wherein a hologram recording is effected in a non-rewritable process.

**19.** A hologram recording method using a hologram recording material as defined in claim 1, the method comprising multiplexed recording including 10 or more recording jobs.

**20.** An optical recording medium comprising a hologram recording material as defined in claim 1.

**21.** An optical recording medium comprising a hologram recording material as defined in claim 1,
wherein the optical recording medium is stored in a light-screening cartridge during storage.

FIG. 1